# EUROPÄISCHE PATENTSCHRIFT

(11) **EP 3 895 261 B1**
(45) Veröffentlichungstag und Bekanntmachung des Hinweises auf die Patenterteilung: **07.02.2024**
(21) Anmeldenummer: 19820685.6
(22) Anmeldetag: 05.12.2019
(51) Int. Cl.: H01S 3/067

(54) **LASERSYSTEM UND VERFAHREN ZUM BETREIBEN EINES SOLCHEN LASERSYSTEMS**
LASER SYSTEM AND METHOD FOR OPERATING A LASER SYSTEM OF THIS TYPE
SYSTÈME LASER ET PROCÉDÉ DE FONCTIONNEMENT D'UN TEL SYSTÈME LASER

(30) Priorität: 10.12.2018 DE 102018221363
(43) Veröffentlichungstag der Anmeldung: 20.10.2021
(73) Patentinhaber: TRUMPF Laser GmbH, 78713 Schramberg (DE)
(72) Erfinder: BUDNICKI, Aleksander, 79194 Gundelfingen (DE)
(74) Vertreter: Trumpf Patentabteilung
(86) Internationale Anmeldenummer: PCT/EP2019/083914
(87) Internationale Veröffentlichungsnummer: WO 2020/120293

(56) Entgegenhaltungen:
- WO-A1-2018/015682
- WO-A1-2018/184943
- US-A1- 2004 240 037

## Beschreibung

Die Erfindung betrifft ein Lasersystem sowie ein Verfahren zum Betreiben eines solchen Lasersystems.

Aus der deutschen Patentschrift DE 10 2016 124 087 B3 geht ein Lasersystem mit einem Anregungslaser hervor, der eingerichtet ist zur Erzeugung von Laserpulsen, einem Verstärker, der eingerichtet ist zur Verstärkung von Laserlicht, sowie einer Hochfrequenz-Laserpulsquelle, die eingerichtet ist zur Erzeugung eines GHz-Laserpulszugs mit einer Einzelpuls-Repetitionsrate von Einzelpulsen in dem GHz-Laserpulszug von mindestens 0,5 GHz, hier konkret von mindestens 1 GHz, insbesondere mehr als 5 GHz.

Die WO 2018/015682, WO 2018/184943 und US 2004/240037 beschreiben ähnliche Lasersysteme.

Es hat sich herausgestellt, dass eine Oberflächenbearbeitung mit solchen GHz-Laserpulszügen eine sehr hohe Effizienz und zugleich Oberflächenqualität, insbesondere im Vergleich zu einer Bearbeitung mit Niederfrequenz-Laserpulszügen bei Einzelpuls-Repetitionsraten von weniger als 0,5 GHz zeigt. Zugleich weist aber auch die Bearbeitung mit Niederfrequenz-Laserpulszügen Vorteile auf, und es kann insbesondere wünschenswert sein, eine Oberfläche sowohl mit GHz-Laserpulszügen als auch mit Niederfrequenz-Laserpulszügen bearbeiten zu können, insbesondere um die Vorteile beider Modi nutzen zu können. Bekannte Lasersysteme sind allerdings so ausgelegt, dass sie entweder Niederfrequenz-Laserpulszüge mit Einzelpuls-Repetitionsraten von weniger als 0,5 GHz oder GHz-Laserpulszüge erzeugen. Eine Nutzung beider Modi zur Bearbeitung ein und derselben Oberfläche ist daher sehr aufwendig und teuer, da hierzu zwei separate Lasersysteme genutzt werden müssen.

Der Erfindung liegt die Aufgabe zugrunde, ein Lasersystem und ein Verfahren zum Betreiben eines Lasersystems zu schaffen, wobei die genannten Nachteile nicht auftreten.

Die Aufgabe wird gelöst, indem die vorliegende technische Lehre bereitgestellt wird, insbesondere die Lehre der unabhängigen Ansprüche sowie der in den abhängigen Ansprüchen und der Beschreibung offenbarten Ausführungsformen.

Die Aufgabe wird gelöst, indem ein Lasersystem mit wenigstens einem Anregungslaser, einem Verstärker und einer Hochfrequenz-Laserpulsquelle derart weitergebildet wird, dass in Lichtausbreitungsrichtung vor dem Verstärker eine Strahlumschalteinrichtung angeordnet ist, die zwischen einer Hochfrequenz-Funktionsstellung und einer Niederfrequenz-Funktionsstellung schaltbar ist. Die Strahlumschalteinrichtung ist dabei eingerichtet, um in der Hochfrequenz-Funktionsstellung dem Verstärker wenigstens einen GHz-Laserpulszug der Hochfrequenz-Laserpulsquelle zur Verstärkung zuzuleiten, und um in der Niederfrequenz-Funktionsstellung dem Verstärker wenigstens einen Niederfrequenz-Laserpulszug des wenigstens einen Anregungslasers mit einer Einzelpuls-Repetitionsrate von einzelnen Laserpulsen in dem Niederfrequenz-Laserpulszug von weniger als 0,5 GHz zur Verstärkung zuzuleiten. Auf diese Weise ist es möglich, mit ein und demselben Lasersystem in einfacher und schneller Weise verschiedene Bearbeitungsmodi, insbesondere entweder GHz-Laserpulszüge oder Niederfrequenz-Laserpulszüge, zur Bearbeitung einer Oberfläche bereitzustellen, wobei in einfacher und schneller Weise zwischen den Bearbeitungsmodi, das heißt hier zwischen der Hochfrequenz-Funktionsstellung einerseits und der Niederfrequenz-Funktionsstellung andererseits, umgeschaltet werden kann. Somit kann eine optimierte Oberflächenbearbeitung in einfacher und vergleichsweise kostengünstiger Weise gewährleistet werden.

Unter einem Anregungslaser wird insbesondere ein Seedlaser verstanden, der bevorzugt eingerichtet ist zur Erzeugung von einzelnen Laserpulsen mit einer zeitlichen Breite von einigen 100 fs, besonders bevorzugt ungefähr 200 fs. Das Lasersystem ist insgesamt bevorzugt als Ultrakurzpuls-System (UKP-System) ausgebildet und insoweit eingerichtet, um Laserpulse zu erzeugen, die eine zeitliche Breite auf der Femtosekunden-Skala oder Pikosekunden-Skala, insbesondere von einigen 10 fs oder einigen 10 ps, aufweisen.

Der Verstärker ist eingerichtet zur Verstärkung von Laserlicht aus dem wenigstens einen Anregungslaser und/oder aus einem weiteren Laser.

Unter einem Laserpulszug, sei es ein GHz-Laserpulszug oder ein Niederfrequenz-Laserpulszug, wird allgemein eine Abfolge von einzelnen Laserpulsen, auch als Einzelpulse bezeichnet, verstanden, die mit einer bestimmten Einzelpuls-Repetitionsrate aufeinanderfolgen. Ein solcher Laserpulszug kann ein Einzelpulszug oder ein Pulspaket sein.

Unter einem Einzelpulszug wird entsprechend eine Abfolge von einzelnen Laserpulsen verstanden, die mit einer bestimmten Einzelpuls-Repetitionsrate aufeinanderfolgen, wobei die Einzelpulse nicht zu definierten Pulspaketen gruppiert sind. Werden mehrere Einzelpulszüge erzeugt, weisen diese insbesondere höchstens zufällig einen gleichen zeitlichen Abstand, vorzugsweise jedoch verschiedene zeitliche Abstände zueinander auf. Die Einzelpulszüge werden also nicht mit einer bestimmten Pulspaket-Repetitionsrate erzeugt.

Ein Pulspaket ist demgegenüber eine Gruppe von mindestens zwei Einzelpulsen, die mit einer bestimmten Einzelpuls-Repetitionsrate, auch als Mikropulsrepetitionsrate bezeichnet, aufeinanderfolgen, wobei mehrere aufeinanderfolgende Pulspakete mit einer bestimmten Pulspaket-Repetitionsrate, auch als Makropulsrepetitionsrate bezeichnet, aufeinanderfolgen. Die Pulspakete weisen also einen konstanten zeitlichen Abstand zueinander auf.

Die Präfixe "GHz-" und "Niederfrequenz-" beziehen sich vor den Begriffen "Laserpulszug", "Einzelpulszug", "Pulspaket", und "Pulspaket-Repetitionsrate" jeweils auf die Einzelpuls-Repetitionsrate der Einzelpulse, und sie geben dabei insbesondere an, ob diese mindestens 0,5 GHz ("GHz-") oder weniger als 0,5 GHz ("Niederfrequenz-") beträgt.

Besonders bevorzugt beträgt die Einzelpuls-Repetitionsrate in dem GHz-Laserpulszug von mindestens 1 GHz bis höchsten 100 GHz, vorzugsweise von mindestens 2 GHz bis höchstens 20 GHz, vorzugsweise bis höchstens 10 GHz, vorzugsweise 1 GHz, 3,5 GHz, oder 5 GHz.

Das Lasersystem ist eingerichtet, um eine Mehrzahl solcher GHz-Laserpulszüge als GHz-Pulspakete zu erzeugen, die ihrerseits mit einer GHz-Pulspaket-Repetitionsrate von mehr als einem kHz, oder im MHz-Bereich, oder auch von weniger als einem kHz, insbesondere bei Hochfrequenz-Laserquellen mit Pulse on Demand-Funktion, zeitlich aufeinanderfolgen. Die Laserpulszüge können aber auch als Folge ohne definierte Pulspaket-Repetitionsrate erzeugt werden.

Der Begriff "Lichtausbreitungsrichtung" bezieht sich hier auf die Richtung der Propagation der Laserpulse entlang des Lasersystems, insbesondere die Richtung eines Poynting-Vektors der Laserpulse. Die Lichtausbreitungsrichtung bezieht sich insbesondere auf eine Reihenfolge, in welcher die einzelnen Elemente des Lasersystems von den Laserpulsen durchlaufen werden. Dass die Strahlumschalteinrichtung in Lichtausbreitungsrichtung vor dem Verstärker angeordnet ist, bedeutet also insbesondere, dass ein Laserpuls zuerst die Strahlumschalteinrichtung und danach den Verstärker passiert.

Die Einzelpuls-Repetitionsrate, mit der die Einzelpulse in der Niederfrequenz-Funktionsstellung den Verstärker erreichen oder von dem Lasersystem emittiert werden, beträgt hier weniger als 0,5 GHz, vorzugsweise von mindestens 0,01 MHz bis höchstens 100 MHz, vorzugsweise von mindestens 1 MHz bis höchstens 90 MHz, vorzugsweise von mindestens 5 MHz bis höchstens 15 MHz, vorzugsweise höchstens 10 MHz. Somit liegt in dem Lasersystem eine deutliche Separation der Einzelpuls-Repetitionsrate in der Hochfrequenz-Funktionsstellung einerseits und der Einzelpuls-Repetitionsrate in der Niederfrequenz-Funktionsstellung andererseits vor.

Der Verstärker kann einteilig oder mehrteilig ausgebildet sein. Insbesondere handelt es sich bei dem Verstärker bevorzugt um einen Hauptverstärker des Lasersystems, wobei vor dem Hauptverstärker in Lichtausbreitungsrichtung wenigstens ein Vorverstärker, vorzugsweise eine Mehrzahl von Vorverstärkern angeordnet ist. Insbesondere kann der Verstärker eine Mehrzahl von Verstärkerstufen aufweisen, die in Lichtausbreitungsrichtung hintereinander, also seriell angeordnet sind. Die Verstärkerstufen können aber auch zusätzlich oder alternativ parallel zueinander angeordnet sein, wobei bevorzugt die Laserpulse vor den parallel angeordneten Verstärkern aufgeteilt und hinter diesen wiederum miteinander kombiniert werden, insbesondere über eine Polarisationskopplung oder kohärente Kopplung. Vorzugsweise ist ein Hauptverstärker ein letzter Verstärker in einer Verstärkerkette aus einer Mehrzahl von Verstärkern.

Es ist möglich, dass die Laserpulse in der Niederfrequenz-Funktionsstellung der Strahlumschalteinrichtung zu Niederfrequenz-Pulspaketen (Makropuls) mit jeweils mindestens zwei Einzelpulsen kombiniert werden, mit einer Einzelpuls-Repetitionsrate der Einzelpulse (Mikropulse) innerhalb eines solchen Niederfrequenz-Pulspakets (Mikropulsrepetitionsrate) von weniger als 0,5 GHz, vorzugsweise von mindestens 0,01 MHz bis höchstens 100 MHz, vorzugsweise von mindestens 1 MHz bis höchstens 90 MHz, vorzugsweise von mindestens 5 MHz bis höchstens 15 MHz, vorzugsweise höchstens 10 MH. Die Niederfrequenz-Pulspakete folgen bevorzugt zeitlich aufeinander mit einer Niederfrequenz-Pulspaket-Repetitionsrate (Makropulsrepetitionsrate) von einigen 100 kHz, einigen 10 kHz oder einigen kHz. Somit unterscheiden sich auch die Niederfrequenz-Pulspakete der Niederfrequenz-Funktionsstellung deutlich von den GHz-Pulspaketen in der Hochfrequenz-Funktionsstellung anhand der jeweiligen Einzelpuls-Repetitionsrate.

Gemäß einer Weiterbildung der Erfindung ist vorgesehen, dass die Hochfrequenz-Laserpulsquelle als Laserdiode ausgebildet ist. Dies stellt eine besonders einfache Ausgestaltung der Hochfrequenz-Laserpulsquelle dar. Die Laserdiode ist bevorzugt eingerichtet zur Erzeugung von Pikosekunden-Laserpulsen. Eine solche Laserdiode ist bevorzugt als schnell schaltbare Diode ausgebildet, die Pulsfolgen mit einer Einzelpuls-Repetitionsrate im GHz-Bereich erzeugen kann, sodass die Laserdiode unmittelbar als Hochfrequenz-Laserpulsquelle verwendet werden kann.

Es ist auch möglich, dass die Hochfrequenz-Laserpulsquelle eine Laserdiode aufweist, die nicht selbst Laserpulse mit einer Einzelpuls-Repetitionsrate im Gigahertzbereich emittiert, wobei dann der Laserdiode ein Repetitionsratenvervielfacher, insbesondere der im Folgenden noch erläuterten Art oder auch einer anderen Bauart, nachgeschaltet ist, wobei in diesem Fall die Laserdiode und der Repetitionsratenvervielfacher gemeinsam die Hochfrequenz-Laserpulsquelle bilden.

Alternativ ist es möglich, dass die Hochfrequenz-Laserpulsquelle als modengekoppelter GHz-Oszillator ausgebildet ist. Weiter alternativ ist es möglich, dass die Hochfrequenz-Laserpulsquelle ausgebildet ist, wie dies in der deutschen Patentschrift DE 10 2016 124 087 B3 für die dort offenbarte optische Komponente zur Erzeugung von Laserpulsen in einem Burstbetrieb offenbart ist.

Alternativ ist es auch möglich, dass sowohl der Anregungslaser als auch die Hochfrequenz-Laserpulsquelle eine Laserdiode aufweisen, insbesondere aus einer Laserdiode, bevorzugt aus einer selben Laserdiode, gebildet sind. Insbesondere wird bevorzugt dieselbe Laserdiode, die eingerichtet ist zur Erzeugung von Pikosekunden-Laserpulsen und/oder zur Erzeugung von Pulsfolgen mit einer Einzelpuls-Repetitionsrate im GHz-Bereich, sowohl als Anregungslaser als auch als Hochfrequenz-Laserpulsquelle verwendet. In diesem Fall wird insbesondere über eine der Laserdiode nachgeschaltete Pulsauswahleinrichtung bestimmt, ob das Lasersystem in der Hochfrequenz-Funktionsstellung oder in der Niederfrequenz-Funktionsstellung betrieben wird. Insbesondere sind mittels der Pulsauswahleinrichtung, die insbesondere als optischer Modulator ausgebildet sein kann, beispielsweise als akustooptischer Modulator, als elektrooptischer Modulator, oder als mikro-elektro-mechanisches System, Laserpulse aus der von der Laserdiode erzeugten Pulsfolge von Einzelpulsen auswählbar, sodass abhängig von der Ansteuerung der Pulsauswahleinrichtung Laserpulszüge, nämlich GHz-Laserpulszüge oder Niederfrequenz-Laserpulszüge, jeweils als Einzelpulszüge oder als Pulspakete erzeugt werden können. Die Pulsauswahleinrichtung kann in Lichtausbreitungsrichtung vor oder hinter dem Verstärker angeordnet sein. Bevorzugt ist sie vor dem Verstärker angeordnet.

Gemäß einer Weiterbildung der Erfindung ist vorgesehen, dass die Strahlumschalteinrichtung wenigstens einen Strahlwähler aufweist. Alternativ oder zusätzlich weist die Strahlumschalteinrichtung wenigstens einen Strahlverteiler auf.

Der Strahlwähler ist bevorzugt als Strahlumschalter ausgebildet. Dabei wird hier unter einem Strahlumschalter eine Einrichtung verstanden, die eingerichtet ist, um zwischen zwei Quellen von Laserpulsen, Strahlquellen oder Strahlquellenbereichen, auszuwählen, und wahlweise Laserpulse aus der einen Quelle oder Laserpulse aus der anderen Quelle in Richtung einer vorzugsweise für alle Laserpulse identischen Zielposition zu leiten.

Der Strahlwähler kann aber auch als passiver Strahlkombinierer ausgebildet sein, der - insbesondere abhängig von dem Betriebszustand eines anderen Elements - wahlweise Laserpulse aus der einen Quelle oder Laserpulse aus der anderen Quelle in Richtung der vorzugsweise für alle Laserpulse identischen Zielposition leitet.

Unter einem Strahlverteiler wird eine Einrichtung verstanden, die eingerichtet ist, um einen Laserstrahl oder Laserpuls wahlweise entlang einer ersten Strahlstrecke oder entlang einer zweiten Strahlstrecke zu leiten, oder um den Laserstrahl oder Laserpuls auf die erste Strahlstrecke einerseits und die zweite Strahlstrecke andererseits aufzuteilen.

In einer bevorzugten Ausgestaltung des Lasersystems genügt es, dass die Strahlumschalteinrichtung wenigstens einen als Strahlumschalter ausgebildeten Strahlwähler aufweist oder als Strahlumschalter ausgebildet ist. Dies ist insbesondere der Fall, wenn als Hochfrequenz-Laserpulsquelle - insbesondere zusätzlich zu dem Anregungslaser - eine Laserdiode, ein modengekoppelter GHz-Oszillator oder eine GHz-Quelle, wie sie in DE 10 2016 124 087 B3 beschrieben ist, verwendet wird. Der Strahlumschalter kann dann in einfacher Weise zwischen dem Anregungslaser einerseits und der Hochfrequenz-Laserpulsquelle andererseits umschalten.

Es ist aber auch bevorzugt möglich, dass die Strahlumschalteinrichtung sowohl wenigstens einen Strahlverteiler als auch wenigstens einen Strahlwähler aufweist, wobei in besonders bevorzugter Weise aus dem Anregungslaser stammende Laserpulse zunächst durch den Strahlverteiler auf verschiedene Strahlstrecken aufgeteilt werden, wobei anschließend aus den verschiedenen, als verschiedene Quellen wirkenden Strahlstrecken stammende Laserpulse durch den Strahlwähler je nach Funktionsstellung des Strahlverteilers und/oder des Strahlwählers ausgewählt und zu der Zielposition geleitet werden.

Unter der Zielposition wird insbesondere ein Element des Lasersystems, insbesondere ein optisches Element, oder eine Bearbeitungsposition, insbesondere auf einer mit dem Lasersystem bearbeiteten Oberfläche, in Lichtausbreitungsrichtung hinter dem Strahlwähler verstanden. Insbesondere kann die Zielposition der Verstärker sein. Vorzugsweise ist die Zielposition ein Punkt oder ein Bereich auf einer Oberfläche eines durch das Lasersystem behandelten Werkstücks.

Gemäß einer Weiterbildung der Erfindung ist vorgesehen, dass die Hochfrequenz-Laserpulsquelle als Repetitionsratenvervielfacher ausgebildet ist. Dabei sind dem Repetitionsratenvervielfacher vorzugsweise Laserpulse aus dem Anregungslaser zuleitbar. Der Repetitionsratenvervielfacher ist eingerichtet, um eine Einzelpuls-Repetitionsrate der Einzelpulse des Anregungslasers zu vervielfachen. Auf diese Weise kann aus der ursprünglich vergleichsweise niedrigen Einzelpuls-Repetitionsrate der Einzelpulse letztlich eine Einzelpuls-Repetitionsrate im GHz-Bereich erzeugt werden. Vorteilhaft bei der hier beschriebenen Ausgestaltung ist, dass es keiner separaten Lichtquelle, insbesondere keines separaten Lasers, insbesondere keiner Laserdiode, zur Bereitstellung der Hochfrequenz-Laserpulsquelle bedarf. Vielmehr wird der Anregungslaser genutzt, um die GHz-Laserpulszüge zu erzeugen, insbesondere indem Laserpulse aus dem Anregungslaser dem Repetitionsratenvervielfacher zugeleitet werden. Vorzugsweise dient der Anregungslaser somit sowohl zur Bereitstellung von Niederfrequenz-Laserpulszügen in der Niederfrequenz-Funktionsstellung, als auch zur Bereitstellung von Laserpulsen zur Erzeugung von GHz-Laserpulszügen in der Hochfrequenz-Funktionsstellung, vermittelt über den Repetitionsratenvervielfacher.

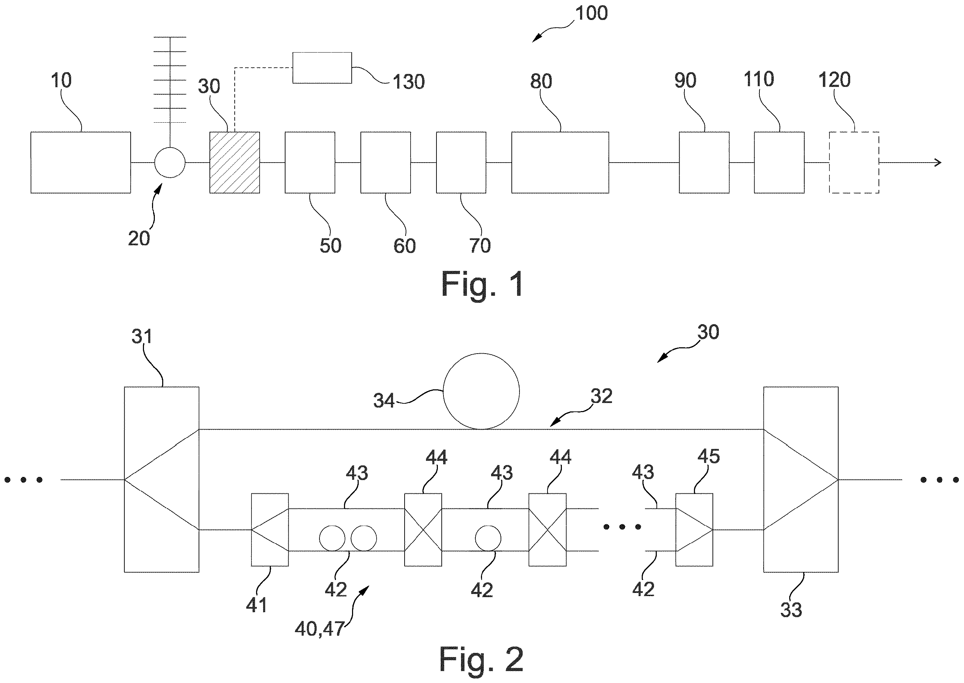

Der Repetitionsratenvervielfacher weist bevorzugt an einer Eingangsseite einen Strahlteiler auf, der einen ankommenden Laserpuls oder einen Laserpulszug aufteilt auf eine Verzögerungsstrecke einerseits und eine Durchgangsstrecke andererseits. Die Verzögerungsstrecke ist dabei eingerichtet, um den Laserpuls oder den Laserpulszug relativ zu der Durchgangsstrecke zu verzögern. Die Verzögerungsstrecke und die Durchgangsstrecke sind so eingerichtet und aufeinander abgestimmt, dass die Laufzeit des Laserpulses oder des Laserpulszugs durch die Verzögerungsstrecke länger ist, als die Laufzeit durch die Durchgangsstrecke. Dies wird in besonders einfacher Weise bevorzugt dadurch verwirklicht, dass die Verzögerungsstrecke länger ist als die Durchgangsstrecke, in besonders einfacher Weise dadurch, dass die Durchgangsstrecke und die Verzögerungsstrecke jeweils als faseroptische Strecken ausgebildet sind, wobei eine Faserlänge der Verzögerungsstrecke länger ist als eine Faserlänge der Durchgangsstrecke. Der Anteil des Lichts, welches die Verzögerungsstecke durchläuft, wird relativ zu dem Licht, welches die Durchgangsstrecke durchläuft, verzögert, sodass im Ergebnis der Laserpuls oder der Laserpulszug vervielfältigt wird. Vorzugsweise verhält sich die Verzögerungsstrecke zu der Durchgangsstrecke so, dass die Einzelpuls-Repetitionsrate der einzelnen Laserpulse verdoppelt wird. Anschließend werden bevorzugt die Laserpulse in einem Kombinationselement, aufweisend einen Strahlkombinierer und einen Strahlteiler, zunächst kombiniert und dann wiederum aufgeteilt auf eine weitere Verzögerungsstrecke und eine weitere Durchgangsstrecke, wobei erneut die Laserpulse in der Verzögerungsstrecke relativ zu der Durchgangsstrecke verzögert werden, wodurch die Einzelpuls-Repetitionsrate vorzugsweise erneut verdoppelt wird. Dies wird für eine bestimmte Anzahl von Stationen wiederholt, wobei vorzugsweise jeder Station ein Faktor 2 in der Einzelpuls-Repetitionsrate zugeordnet ist. Es ist möglich, dass der Repetitionsratenvervielfacher ausgebildet ist, wie dies in C. Kerse et al., 3,5-GHz intra-burst repetition rate ultrafast Yb-doped fiber laser, Opt. Commun. 366 (2016), 404-409, insbesondere dort zu Figur 1 (b), beschrieben ist. Dabei halbiert sich die Länge der Verzögerungsstrecke bei identischer Länge der Durchgangsstrecke von Station zu Station. In diesem Fall wird ein Einzelpulszug in einer Station des Repetitionsratenvervielfachers um einen halben zeitlichen Einzelpulsabstand verzögert, sodass der verzögerte Einzelpulszug und der nicht-verzögerte Einzelpulszug überlagert, quasi kammartig ineinander geschoben werden.

Alternativ ist es möglich, dass der Repetitionsratenvervielfacher ausgebildet ist, wie dies in der Patentschrift DE 10 2016 124 087 B3 offenbart ist. In diesem Fall verdoppelt sich die Länge der Verzögerungsstrecke bei gleicher Durchgangsstrecke von Station zu Station. Hierbei wird stets eine gesamte Gruppe an einzelnen Laserpulsen um die Gruppenlänge der Gruppe verzögert, sodass die Anzahl der einzelnen Laserpulse in der Gruppe - und damit insbesondere zugleich auch die Gruppe selbst - letztlich jeweils verdoppelt wird. Die Einzelpuls-Repetitionsrate ergibt sich dabei aus der ersten Verzögerung eines Einzelpulses in der ersten Station des Repetitionsratenvervielfachers. Dabei ist die Einzelpuls-Repetitionsrate der Kehrwert der dort realisierten Verzögerungszeit.

Der Repetitionsratenvervielfacher ist vorzugsweise als faseroptischer Repetitionsratenvervielfacher ausgebildet. Insbesondere sind bevorzugt sowohl die Verzögerungsstrecken als auch die Durchgangsstrecken als faseroptische Komponenten ausgebildet.

Gemäß einer Weiterbildung der Erfindung ist vorgesehen, dass die Strahlumschalteinrichtung einen Strahlverteiler aufweist, der eingerichtet ist, um Laserlicht des Anregungslasers zeitlich und/oder räumlich auf den Repetitionsratenvervielfacher einerseits und eine Einzelpulsstrecke andererseits aufzuteilen. Somit werden die Laserpulse des Anregungslasers sowohl für die Bereitstellung der Niederfrequenz-Laserpulszüge als auch zur Erzeugung der GHz-Laserpulszüge in dem Repetitionsratenvervielfacher verwendet, sodass es keines zusätzlichen Lasers bedarf. Eine zeitliche Aufteilung bedeutet dabei insbesondere, dass einzelne Laserpulse zeitabhängig, insbesondere abhängig von der momentanen Funktionsstellung des Lasersystems, entweder der Einzelpulsstrecke oder dem Repetitionsratenvervielfacher zugeleitet werden. Eine räumliche Aufteilung bedeutet insbesondere, dass einzelne Laserpulse aufgeteilt und in verschiedene Raumrichtungen geleitet werden, beispielsweise mittels eines passiven Strahlteilers, der die einzelnen Laserpulse in einem konstanten Aufteilungsverhältnis auf eine erste und eine zweite Raumrichtung aufteilt, oder mittels einer aktiven Stahlschalteinrichtung, welche die einzelnen Laserpulse abhängig von der Funktionsstellung des Lasersystems in die erste Raumrichtung oder in die zweite Raumrichtung leitet.

Die Strahlumschalteinrichtung weist außerdem den Strahlwähler auf, der als aktiver Strahlumschalter oder als passiver Strahlkombinierer ausgebildet sein kann.

Der Strahlwähler ist eingerichtet, um dem Verstärker in der Hochfrequenz-Funktionsstellung wenigstens einen GHz-Laserpulszug aus dem Repetitionsratenvervielfacher und in der Niederfrequenz-Funktionsstellung Laserpulse aus der Einzelpulsstrecke zuzuleiten.

Durch Ansteuerung des Strahlverteilers und/oder des Strahlwählers, insbesondere des Strahlumschalters, kann demnach die Funktionsstellung des Lasersystems eingestellt werden. Durch Wahl der Funktionsstellung des Strahlverteilers und/oder des Strahlwählers wird ausgewählt, aus welcher Strahlstrecke des Lasersystems, mithin der Einzelpulsstrecke oder dem Repetitionsratenvervielfacher, Licht zu der Zielposition geleitet wird. Somit kann in einfacher Weise mittels der Strahlumschalteinrichtung zwischen der Hochfrequenz-Funktionsstellung und der Niederfrequenz-Funktionsstellung geschaltet werden.

Gemäß einer Weiterbildung der Erfindung ist vorgesehen, dass der Strahlverteiler als passiver Strahlteiler, insbesondere mit konstantem Aufteilungsverhältnis, ausgebildet ist. Bevorzugt kann das Aufteilungsverhältnis 20:80 betragen, wobei 20 % der Lichtleistung in eine erste Raumrichtung geleitet werden, wobei 80 % der Lichtleistung in eine zweite, von der ersten Raumrichtung verschiedene Raumrichtungen geleitet werden. Vorzugsweise ist der Strahlteiler so eingerichtet und angeordnet, dass 80 % der Lichtleistung dem Repetitionsratenvervielfacher zugeleitet werden, wobei 20 % der Lichtleistung der Einzelpulsstrecke zugeleitet werden. Dies berücksichtigt in vorteilhafter Weise, dass der Repetitionsratenvervielfacher eine größere Zahl optischer Komponenten aufweist als die Einzelpulsstrecke, sodass Leistungsverluste in dem Repetitionsratenvervielfacher höher sind als entlang der Einzelpulsstrecke. Die Aufteilung 20:80 bezieht sich auf die durch den Strahlteiler weitergeleitete Lichtleistung eines Einzelpulses. Selbstverständlich treten auch in dem Strahlteiler selbst Verluste auf. Die entsprechenden Verluste werden bevorzugt in Lichtausbreitungsrichtung hinter dem Repetitionsratenvervielfacher einerseits und hinter der Einzelpulsstrecke andererseits durch den Verstärker und/oder wenigstens einen Vorverstärker kompensiert, vorzugsweise überkompensiert.

Alternativ ist bevorzugt vorgesehen, dass der Strahlverteiler als aktive Strahlschalteinrichtung ausgebildet ist. Auf diese Weise können - abhängig von der Funktionsstellung des Lasersystems und je nach Schaltstellung der aktiven Strahlschalteinrichtung - Laserpulse entweder der Einzelpulsstrecke oder dem Repetitionsratenvervielfacher zugeleitet werden. Die aktive Strahlschalteinrichtung wird bevorzugt synchron und gleichsinnig mit dem Strahlwähler geschaltet, wenn dieser als aktiver Strahlumschalter ausgebildet ist.

Alternativ ist es auch möglich, dass der Strahlverteiler aus einer Kombination aus einem passiven Strahlteiler und einer aktiven Strahlschalteinrichtung ausgebildet ist. Auch so kann das Laserlicht des Anregungslasers zeitlich und/oder räumlich auf den Repetitionsratenvervielfacher einerseits und die Einzelpulsstrecke andererseits aufgeteilt werden.

Gemäß einer Weiterbildung der Erfindung ist vorgesehen, dass der Strahlwähler als aktive Strahlschalteinrichtung ausgebildet ist. Somit kann in besonders einfacher Weise insbesondere mit einer einzigen optischen Komponente zwischen der Hochfrequenz-Funktionsstellung und der Niederfrequenz-Funktionsstellung umgeschaltet werden.

Alternativ ist es möglich, dass der Strahlwähler als Kombination aus einem passiven Strahlkombinierer mit wenigstens einer aktiven Strahlbeeinflussungseinrichtung ausgebildet ist. Unter einem Strahlkombinierer wird dabei ein optisches Element verstanden, welches eingerichtet ist, um wenigstens zwei aus verschiedenen Quellen oder Strahlstrecken einfallende Laserstrahlen zu einem Laserstrahl zu kombinieren. Der Strahlkombinierer kann beispielsweise ein in Lichtausbreitungsrichtung invers angeordneter Strahlteiler sein, wobei sich die Funktion dieser Komponente abhängig von ihrer Orientierung relativ zur Lichtausbreitungsrichtung umkehrt. Die aktive Strahlbeeinflussungseinrichtung ist eingerichtet zur wahlweisen Ablenkung und/oder Abschwächung des Laserstrahls, und in wenigstens einer Strahlstrecke des Lasersystems, ausgewählt aus dem Repetitionsratenvervielfacher einerseits und der Einzelpulsstrecke andererseits, angeordnet, um wahlweise Licht in dieser Strahlstrecke unvermindert - gegebenenfalls bis auf nicht vermeidbare Verluste - durchzuleiten, oder aber abzulenken, oder abzuschwächen. Auf diese Weise kann die entsprechende Strahlstrecke mit der aktiven Strahlbeeinflussungseinrichtung quasi an- oder abgeschaltet werden, je nach Funktionsstellung der aktiven Strahlbeeinflussungseinrichtung. In besonders bevorzugter Weise ist in jeder Strahlstrecke, also in dem Repetitionsratenvervielfacher und in der Einzelpulsstrecke, jeweils eine aktive Strahlbeeinflussungseinrichtung angeordnet. Auf diese Weise kann wahlweise jeweils eine der Strahlstrecken an- und die andere Strahlstrecke abgeschaltet werden, abhängig von der Funktionsstellung des Lasersystems.

Die aktive Strahlbeeinflussungseinrichtung kann in besonders einfacher Weise als schaltbarer, insbesondere klapp-, kipp- oder drehbarer Spiegel ausgebildet sein, der den Laserstrahl entweder in Richtung des passiven Strahlkombinierers durchlässt oder aber von dem Strahlkombinierer weg ablenkt, beispielsweise in einen Beamdump. Die Strahlbeeinflussungseinrichtung kann aber auch als akustooptischer Modulator, elektrooptischer Modulator, oder mikro-elektro-mechanisches System, oder in anderer geeigneter Weise ausgebildet sein.

In den beiden zuvor genannten Fällen, wobei der Strahlwähler entweder als aktive Strahlschalteinrichtung oder als Kombination aus einem passiven Strahlkombinierer mit wenigstens einer aktiven Strahlbeeinflussungseinrichtung ausgebildet ist, ist der Strahlwähler als Strahlumschalter ausgebildet, das heißt insbesondere als aktiv schaltbares Element mit vorzugsweise zwei Funktionsstellungen.

Gemäß einer Weiterbildung der Erfindung ist vorgesehen, dass der Strahlwähler als passiver Strahlkombinierer ausgebildet ist. Auf diese Weise kann der Strahlwähler besonders einfach ausgestaltet sein. Diese Ausgestaltung ist insbesondere möglich, wenn der Strahlverteiler als aktive Strahlschalteinrichtung oder als Kombination aus einem passiven Strahlteiler und einer aktiven Strahlschalteinrichtung, mithin insgesamt als aktives, in verschiedene Funktionsstellungen schaltbares Element ausgebildet ist. Dabei wird klar, dass es letztlich nur eines aktiv schaltbaren Elements bedarf, entweder auf Seiten des Strahlverteilers oder auf Seiten des Strahlwählers, um zwischen den verschiedenen Funktionsstellungen des Lasersystems umzuschalten. Gleichwohl ist es auch möglich, dass sowohl der Strahlverteiler als auch der Strahlwähler aktive Elemente sind, die dann vorzugsweise synchron und insbesondere gleichsinnig miteinander geschaltet werden, um zwischen der Hochfrequenz-Funktionsstellung und der Niederfrequenz-Funktionsstellung umzuschalten.

Die Strahlumschalteinrichtung kann insbesondere gemäß einem Ausführungsbeispiel als Strahlverteiler einen passiven Strahlteiler zur Aufteilung von Laserlicht auf die Einzelpulsstrecke einerseits und den Repetitionsratenvervielfacher andererseits, und als Strahlwähler eine aktive Strahlschalteinrichtung zur wahlweisen Weiterleitung von Laserlicht aus der Einzelpulsstrecke oder dem Repetitionsratenvervielfacher zu der Zielposition aufweisen.

Gemäß einem anderen Ausführungsbeispiel kann die Strahlumschalteinrichtung sowohl als Strahlverteiler als auch als Strahlwähler eine aktive Strahlschalteinrichtung aufweisen.

Gemäß einem anderen Ausführungsbeispiel kann die Strahlumschalteinrichtung als Strahlverteiler eine Kombination aus einem passiven Strahlteiler und einer aktiven Strahlschalteinrichtung, und als Strahlwähler eine aktive Strahlschalteinrichtung aufweisen.

Gemäß einem anderen Ausführungsbeispiel kann die Strahlumschalteinrichtung als Strahlverteiler einen passiven Strahlteiler und als Strahlwähler eine Kombination aus einem passiven Strahlkombinierer mit wenigstens einer aktiven Strahlbeeinflussungseinrichtung aufweisen.

Gemäß einem anderen Ausführungsbeispiel kann die Strahlumschalteinrichtung als Strahlverteiler einen aktiven Strahlteiler und als Strahlwähler eine Kombination aus einem passiven Strahlkombinierer mit wenigstens einer aktiven Strahlbeeinflussungseinrichtung aufweisen.

Gemäß einem anderen Ausführungsbeispiel kann die Strahlumschalteinrichtung als Strahlverteiler eine Kombination aus einem passiven Strahlteiler und einer aktiven Strahlschalteinrichtung, und als Strahlwähler eine Kombination aus einem passiven Strahlkombinierer mit wenigstens einer aktiven Strahlbeeinflussungseinrichtung aufweisen.

Gemäß einem anderen Ausführungsbeispiel kann die Strahlumschalteinrichtung als Strahlverteiler eine aktive Strahlschalteinrichtung und als Strahlwähler einen passiven Strahlkombinierer aufweisen.

Gemäß einem anderen Ausführungsbeispiel kann die Strahlumschalteinrichtung als Strahlverteiler eine Kombination aus einem passiven Strahlteiler und einer aktiven Strahlschalteinrichtung, und als Strahlwähler einen passiven Strahlkombinierer aufweisen.

Gemäß einer Weiterbildung der Erfindung ist vorgesehen, dass die Strahlumschalteinrichtung zumindest eine aktive Strahlschalteinrichtung aufweist, wobei die aktive Strahlschalteinrichtung ausgebildet ist als akustooptischer Modulator, als elektrooptischer Modulator, oder als mikro-elektro-mechanisches System. Insbesondere ist zuvor, hier und im Folgenden unter einer aktiven Strahlschalteinrichtung in bevorzugter Weise ein akustooptischer Modulator, ein elektrooptischer Modulator, oder ein mikro-elektro-mechanisches System zu verstehen. Diese Elemente sind besonders geeignet, um eine aktive Strahlschaltung zu bewirken. Die aktive Strahlschalteinrichtung kann aber auch in besonders einfacher Weise als schaltbarer, insbesondere klapp-, kipp- oder drehbarer Spiegel ausgebildet sein, oder einen solchen schaltbaren, insbesondere klapp-, kipp- oder drehbaren Spiegel aufweisen.

Gemäß einer Weiterbildung der Erfindung ist vorgesehen, dass das Lasersystem eine Modus-Änderungseinrichtung aufweist, die ihrerseits den Strahlverteiler, den Repetitionsratenvervielfacher, die Einzelpulsstrecke, und den Strahlwähler aufweist. In bevorzugter Ausgestaltung besteht die Modus-Änderungseinrichtung aus dem Strahlverteiler, den Repetitionsratenvervielfacher, der Einzelpulsstrecke, und dem Strahlwähler. Es ist aber auch möglich, dass die Modus-Änderungseinrichtung zusätzliche, weitere Komponenten aufweist.

Gemäß einer Ausgestaltung ist die Modus-Änderungseinrichtung in Lichtausbreitungsrichtung vor einer Pulsauswahleinrichtung angeordnet, wobei die Pulsauswahleinrichtung eingerichtet ist zur Auswahl von Einzelpulsen oder einzelnen Laserpulszügen. Mithilfe der Pulsauswahleinrichtung kann die Anzahl und/oder Rate an tatsächlich auf die Zielposition, insbesondere eine zu bearbeitende Oberfläche, auftreffenden Laserpulsen oder Laserpulszügen beliebig variiert werden, indem nicht jeder Einzelpuls oder jeder Laserpulszug zu der Zielposition durchgelassen wird, sondern nur ausgewählte Einzelpulse oder Laserpulszüge. Insbesondere mittels der Pulsauswahleinrichtung können auch aus Einzelpulsen Niederfrequenz-Pulspakete mit definierter Niederfrequenz-Pulspaket-Repetitionsrate oder GHz-Pulspakete mit definierter GHz-Pulspaket-Repetitionsrate erzeugt werden.

Die Pulsauswahleinrichtung kann in bevorzugter Weise vor dem Verstärker und/oder vor einem Vorverstärker angeordnet sein. In diesem Fall kann die Pulsauswahleinrichtung insbesondere auch verwendet werden, um eine Beaufschlagung dieser Komponenten mit einer zu hohen Lichtleistung zu vermeiden.

Die Pulsauswahleinrichtung kann außerdem vorteilhaft verwendet werden, um die Amplitude des ausgehenden Laserlichts des Lasersystems zu steuern.

Eine Anordnung der Modus-Änderungseinrichtung vor der Pulsauswahleinrichtung hat den Vorteil, dass eine besonders gute Einstellung der Amplitude des ausgehenden Laserlichts für das Lasersystem möglich ist.

Alternativ oder zusätzlich ist es möglich, dass die Modus-Änderungseinrichtung vor einem ersten Vorverstärker des Lasersystems angeordnet ist. Dies ist vorteilhaft, da die Modus-Änderungseinrichtung nur mit vergleichsweise geringer Lichtleistung beaufschlagt und insoweit geschont wird.

Alternativ oder zusätzlich ist bevorzugt vorgesehen, dass die Modus-Änderungseinrichtung bevorzugt vor einem Pulsstrecker des Lasersystems angeordnet ist. Der Pulsstrecker dient dabei dazu, einen einzelnen Laserpuls des Anregungslasers zeitlich zu strecken und so die weitere Modifizierung des Laserpulses für die eingesetzten Komponenten beschädigungsfrei zu ermöglichen. Insbesondere ist eine Verstärkung in dem Verstärker sowie vorzugsweise wenigstens einem Vorverstärker beschädigungsfrei für die Komponenten möglich, wenn ein durch den Anregungslaser erzeugter Laserpuls zunächst durch den Pulsstrecker gestreckt wird. Ist die Modus-Änderungseinrichtung und damit insbesondere der Repetitionsratenvervielfacher vor dem Pulsstrecker angeordnet, sieht dieser kurze Laserpulse, die gegebenenfalls eine hohe Pulsspitzenleistung aufweisen können, sodass vorteilhaft mit einem kleinen Ausgangssignal, das heißt einer kleinen Pulsleistung, des Anregungslasers gearbeitet wird.

Alternativ oder zusätzlich ist bevorzugt vorgesehen, dass die Modus-Änderungseinrichtung hinter dem ersten Vorverstärker angeordnet ist.

Alternativ oder zusätzlich ist es möglich, dass die Modus-Änderungseinrichtung hinter der Pulsauswahleinrichtung angeordnet ist. In diesem Fall wird durch den Repetitionsratenvervielfacher aus einzelnen, ausgewählten Laserpulsen ein GHz-Laserpulszug erzeugt, der sehr steile Flanken, dafür jedoch wenig Signal hat.

In bevorzugter Ausgestaltung ist es auch möglich, dass die Modus-Änderungseinrichtung hinter dem Pulsstrecker und vor der Pulsauswahleinrichtung angeordnet ist. In diesem Fall erhält die Modus-Änderungseinrichtung relativ viel Signal, allerdings können bei Verwendung einer vergleichsweise langsamen, dafür aber kostengünstigen und zuverlässigen Pulsauswahleinrichtung, wie beispielsweise einem akustooptischen Modulator, die erzeugten Laserpulszüge aufgrund der gestreckten Einzelpulse zeitlich geformt werden, sodass flache Flanken entstehen. Insbesondere können die Flanken einer Einhüllenden der Laserpulszüge abflachen. Dies ist unkritisch, wenn zeitlich hinreichend lange Laserpulszüge erzeugt werden. Alternativ ist es aber auch möglich, als Pulsauswahleinrichtung einen schnellen Modulator, insbesondere einen elektrooptischen Modulator, zu verwenden.

Gemäß einer Weiterbildung der Erfindung ist vorgesehen, dass das Lasersystem in Lichtausbreitungsrichtung hinter dem Anregungslaser - insbesondere in der angegebenen Reihenfolge - einen Pulsstrecker, einen ersten Vorverstärker, vorzugsweise einen zweiten Vorverstärker, den Verstärker, und einen Pulskompressor aufweist. Dabei werden in vorteilhafter Weise die von dem Anregungslaser emittierten Laserpulse in dem Pulsstrecker zeitlich gedehnt, in dem ersten Vorverstärker und vorzugsweise dem zweiten Vorverstärker vorverstärkt, in dem Verstärker verstärkt, und schließlich in dem Pulskompressor wiederum zeitlich komprimiert, um zeitlich kurze, insbesondere weniger als 50 ps, vorzugsweise weniger als 400 fs lange, intensive Laserpulse mit hoher Leistungsdichte zu erhalten. Dabei sind vorzugsweise zumindest der erste Vorverstärker, gegebenenfalls der zweite Vorverstärker, und der Verstärker als faseroptische Komponenten ausgebildet. In bevorzugter Ausgestaltung ist auch der Anregungslaser ein Faserlaser. Auch der Pulsstrecker kann als faseroptische Komponente ausgebildet sein. Der Pulskompressor ist in bevorzugter Weise nicht als faseroptische Komponente ausgebildet, vielmehr propagieren die Laserpulse innerhalb des Pulskompressors und in Lichtausbreitungsrichtung hinter dem Pulskompressor außerhalb von Fasern, insbesondere in Vakuum, Luft, oder einem Gas, da hier Leistungsdichten erreicht werden, die sonst zur Zerstörung insbesondere faseroptischer Komponenten führen könnten.

Gemäß einer Ausgestaltung kann die Modus-Änderungseinrichtung hinter dem Anregungslaser und vor dem Pulsstrecker angeordnet sein. Gemäß einer anderen Ausgestaltung kann die Modus-Änderungseinrichtung hinter dem Pulsstrecker und vor dem ersten Vorverstärker angeordnet sein. Gemäß einer anderen Ausgestaltung kann die Modus-Änderungseinrichtung hinter dem ersten Vorverstärker und vor dem Verstärker angeordnet sein.

Vorzugsweise weist das Lasersystem zusätzlich die Pulsauswahleinrichtung auf. Diese kann gemäß einer Ausgestaltung hinter dem Pulsstrecker und vor dem ersten Vorverstärker, gemäß einer anderen Ausgestaltung hinter dem ersten Vorverstärker und vor dem Verstärker, gemäß einer anderen Ausgestaltung hinter dem ersten Vorverstärker und vor dem zweiten Vorverstärker, gemäß einer weiteren Ausgestaltung hinter dem zweiten Vorverstärker und vor dem Verstärker angeordnet sein.

Die Modus-Änderungseinrichtung kann in bevorzugter Weise jeweils unmittelbar vor oder unmittelbar hinter der Pulsauswahleinrichtung angeordnet sein, es ist aber auch möglich, dass die Modus-Änderungseinrichtung und die Pulsauswahleinrichtung nicht unmittelbar aufeinanderfolgend angeordnet sind.

Gemäß einer weiteren Ausgestaltung weist das Lasersystem bevorzugt eine zusätzliche, zweite Pulsauswahleinrichtung auf, die in Lichtausbreitungsrichtung hinter dem Verstärker angeordnet ist. Auch mittels der zweiten Pulsauswahleinrichtung können insbesondere aus Einzelpulsen Niederfrequenz-Pulspakete mit definierter Niederfrequenz-Pulspaket-Repetitionsrate oder GHz-Pulspakete mit definierter GHz-Pulspaket-Repetitionsrate erzeugt werden.

Ist die Pulsauswahleinrichtung hinter dem ersten Vorverstärker angeordnet, kann dieser besser ausgelastet werden, da ihn mehr Laserpulse erreichen, als wenn er hinter der Pulsauswahleinrichtung angeordnet ist.

Gemäß einer Weiterbildung der Erfindung ist vorgesehen, dass der Anregungslaser als Faseroszillator ausgebildet ist. Dies stellt eine besonders geeignete Ausgestaltung des Anregungslasers dar, insbesondere in Kombination mit weiteren faseroptischen Komponenten des Lasersystems.

Gemäß einer Weiterbildung der Erfindung ist vorgesehen, dass das Lasersystem eine Steuereinrichtung aufweist, die eingerichtet ist zur Ansteuerung der Strahlumschalteinrichtung. Mithilfe der Steuereinrichtung ist es so möglich, wahlweise zwischen der Hochfrequenz-Funktionsstellung und der Niederfrequenz-Funktionsstellung zu schalten.

Die Aufgabe wird schließlich auch gelöst, indem ein Verfahren zum Betreiben eines Lasersystems, insbesondere eines erfindungsgemäßen Lasersystems oder eines Lasersystems nach einem der zuvor beschriebenen Ausführungsbeispiele, geschaffen wird, wobei eine Strahlumschalteinrichtung des Lasersystems wahlweise in eine Hochfrequenz-Funktionsstellung und eine Niederfrequenz-Funktionsstellung geschaltet wird, um in der Hochfrequenz-Funktionsstellung wenigstens einen GHz-Laserpulszug mit einer Einzelpuls-Repetitionsrate von Einzelpulsen in dem GHz-Laserpulszug von mindestens 0,5 GHz von einer Hochfrequenz-Laserpulsquelle zu einer Zielposition zu leiten, und um in der Niederfrequenz-Funktionsstellung wenigstens einen Niederfrequenz-Laserpulszug von wenigstens einem Anregungslaser mit einer Einzelpuls-Repetitionsrate von einzelnen Laserpulsen in dem Niederfrequenz-Laserpulszug von weniger als 0,5 GHz zu der Zielposition zu leiten. In Zusammenhang mit dem Verfahren verwirklichen sich insbesondere die Vorteile, die bereits in Zusammenhang mit dem Lasersystem beschrieben wurden.

Im Rahmen des Verfahrens ist es nicht zwingend nötig, dass die Strahlumschalteinrichtung vor einem Verstärker angeordnet ist. Vielmehr ist es auch möglich, dass die Stahlumschalteinrichtung in Lichtausbreitungsrichtung hinter dem Verstärker angeordnet ist, wobei dann der Strahlumschalteinrichtung bevorzugt bereits verstärkte Laserpulse der Hochfrequenz-Laserpulsquelle einerseits sowie des Anregungslasers andererseits als Einzelpulszüge oder Pulspakete zugeführt werden. Im Übrigen ist aber auch in dieser Ausführungsform das Lasersystem, welches im Rahmen des Verfahrens betrieben wird, bevorzugt so ausgestaltet, wie dies zuvor im Zusammenhang mit dem erfindungsgemäßen Lasersystem sowie den bevorzugten Ausgestaltungen desselben beschrieben wurde.

Schließlich wird die Aufgabe auch gelöst, indem ein Lasersystem geschaffen wird, welches eine Hochfrequenz-Laserpulsquelle, einen Anregungslaser und eine Strahlumschalteinrichtung aufweist, wobei das Lasersystem eingerichtet ist zur Durchführung eines erfindungsgemäßen Verfahrens oder eines Verfahrens nach einem der zuvor beschriebenen Ausführungsformen. In Zusammenhang mit dem Lasersystem ergeben sich somit insbesondere die Vorteile, die bereits in Zusammenhang mit dem Verfahren erläutert wurden.

Wie bereits zu dem Verfahren ausgeführt, ist es bei diesem Lasersystem insbesondere nicht zwingend erforderlich, dass die Strahlumschalteinrichtung in Lichtausbreitungsrichtung vor einem Verstärker angeordnet ist, vielmehr kann die Strahlumschalteinrichtung auch hinter einem Verstärker angeordnet sein, wobei dann der Stahlumschalteinrichtung bereits verstärkte Laserpulse aus der Hochfrequenz-Laserpulsquelle einerseits und dem Anregungslaser andererseits zugeführt werden. Insbesondere weist das Lasersystem bevorzugt zwei Verstärker auf, nämlich einen der Hochfrequenz-Laserpulsquelle zugeordneten Verstärker, und einen einer Einzelpulsstrecke zugeordneten Verstärker, wobei zumindest die Einzelpulsstrecke mit Laserpulsen aus dem Anregungslaser gespeist wird.

Die Hochfrequenz-Laserpulsquelle kann einen separaten Laser zur Erzeugung von Laserpulsen, insbesondere eine Laserdiode, aufweisen. Es ist aber möglich, dass auch die Hochfrequenz-Laserpulsquelle mit Laserpulsen aus dem Anregungslaser gespeist wird. Insoweit kann die Hochfrequenz-Laserpulsquelle insbesondere als Repetitionsratenvervielfacher, insbesondere mit zugeordnetem Verstärker, eingerichtet sein.

Auch ist es möglich, dass sowohl die Hochfrequenz-Laserpulsquelle als auch der Anregungslaser eine Laserdiode aufweisen, insbesondere aus einer Laserdiode bestehen, wobei insbesondere auch eine Ausgestaltung möglich ist, bei der ein und dieselbe Laserdiode sowohl die Hochfrequenz-Laserpulsquelle als auch den Anregungslaser bildet. Mit einer Pulsauswahleinrichtung können dann von dieser Laserdiode erzeugte Einzelpulse bezüglich ihrer Einzelpuls-Repetitionsrate heruntergetaktet, und/oder zu GHz-Pulspaketen oder Niederfrequenz-Pulspaketen geschnitten werden. Somit sind mittels der Laserdiode und der Pulsauswahleinrichtung alle zuvor beschriebenen Funktionsstellungen und Funktionsweisen des Lasersystems darstellbar. Die Laserdiode ist bevorzugt eingerichtet zur Erzeugung von Pikosekunden-Laserpulsen, wobei sie bevorzugt als schnell schaltbare Diode ausgebildet ist, die Pulsfolgen mit einer Einzelpuls-Repetitionsrate im GHz-Bereich erzeugen kann. Die Laserdiode kann dann insbesondere unmittelbar als Hochfrequenz-Laserpulsquelle verwendet werden.

Die Erfindung wird im Folgenden anhand der Zeichnung näher erläutert. Dabei zeigen:
- Figur 1: eine schematische Darstellung eines ersten Ausführungsbeispiels eines Lasersystems;
- Figur 2: eine schematische Darstellung eines Ausführungsbeispiels einer Modus-Änderungseinrichtung;
- Figur 3: eine schematische Darstellung eines zweiten Ausführungsbeispiels des Lasersystems;
- Figur 4: eine schematische Darstellung eines dritten Ausführungsbeispiels des Lasersystems;
- Figur 5: eine schematische Darstellung eines vierten Ausführungsbeispiels des Lasersystems;
- Figur 6: eine schematische Darstellung eines fünften Ausführungsbeispiels des Lasersystems, und
- Figur 7: eine schematische Darstellung einer Funktionsweise eines erfindungsgemäßen Lasersystems.

**Fig. 1** zeigt eine schematische Darstellung eines ersten Ausführungsbeispiels eines Lasersystems 100. Dieses weist einen Anregungslaser 10 auf, der eingerichtet ist zur Erzeugung von Laserpulsen, insbesondere mit einer Einzelpuls-Repetitionsrate von weniger als 0,5 GHz, vorzugsweise von mindestens 0,01 MHz bis höchstens 100 MHz, vorzugsweise von mindestens 1 MHz bis höchstens 90 MHz, vorzugsweise von mindestens 5 MHz bis höchstens 15 MHz, vorzugsweise höchstens 10 MH, sowie einem Verstärker 80, der eingerichtet ist zur Verstärkung von Laserlicht. Das Lasersystem 100 weist außerdem eine in Figur 2 dargestellte Hochfrequenz-Laserpulsquelle 40 auf, die bei dem Ausführungsbeispiel gemäß Figur 1 Teil einer Modus-Änderungseinrichtung 30 ist. Die Hochfrequenz-Laserpulsquelle 40 ist eingerichtet zur Erzeugung eines GHz-Laserpulszugs mit einer Einzelpuls-Repetitionsrate in dem GHz-Laserpulszug von mindestens 0,5 GHz, vorzugsweise von wenigstens 1 GHz bis höchstens 100 GHz, vorzugsweise von mindestens 2 GHz bis höchstens 10 GHz, vorzugsweise 3,5 GHz oder 5 GHz.

Im Lichtausbreitungsrichtung vor dem Verstärker 80 ist eine ebenfalls in Figur 2 dargestellte Strahlumschalteinrichtung 31, 33 angeordnet, die hier bei dem Ausführungsbeispiel gemäß Figur 1 ebenfalls Teil der Modus-Änderungseinrichtung 30 ist. Die Strahlumschalteinrichtung 31, 33 ist zwischen einer Hochfrequenz-Funktionsstellung und einer Niederfrequenz-Funktionsstellung schaltbar und eingerichtet, um in der Hochfrequenz-Funktionsstellung dem Verstärker 80 wenigstens einen GHz-Laserpulszug der Hochfrequenz-Laserpulsquelle 40, vorzugsweise eine Mehrzahl von GHz-Laserpulszügen, zur Verstärkung zuzuleiten, und um in der Niederfrequenz-Funktionsstellung dem Verstärker 80 wenigstens einen Niederfrequenz-Laserpulszug des wenigstens einen Anregungslasers 10, vorzugsweise eine Mehrzahl von Niederfrequenz-Pulszügen, mit einer Einzelpuls-Repetitionsrate von einzelnen Laserpulsen in dem Niederfrequenz-Laserpulszug von weniger als 0,5 GHz zur Verstärkung zuzuleiten. Somit ist es bei dem hier vorgeschlagenen Lasersystem 100 in vorteilhafter Weise möglich, zwischen der Erzeugung von GHz-Laserpulszügen einerseits, und der Erzeugung von Niederfrequenz-Laserpulszügen andererseits umzuschalten, und so eine Mehrzahl von Bearbeitungsmodi zur Bearbeitung von Werkstücken, insbesondere von Werkstück-Oberflächen in einfacher und vergleichsweise kostengünstiger Weise bereitzustellen.

Das Lasersystem 100 gemäß dem ersten Ausführungsbeispiel von Figur 1 weist außerdem in Lichtausbreitungsrichtung hinter dem Anregungslaser 10 einen Pulsstrecker 20, die Modus-Änderungseinrichtung 30, einen ersten Vorverstärker 50, einen zweiten Vorverstärker 70, den Verstärker 80, und einen Pulskompressor 110 auf.

In bevorzugter Weise weist das Lasersystem 100 außerdem eine Pulsauswahleinrichtung 60 auf, die hier zwischen dem ersten Vorverstärker 50 und dem zweiten Vorverstärker 70 angeordnet ist. Weiterhin weist das Lasersystem 100 in bevorzugter Weise eine weitere, zweite Pulsauswahleinrichtung 90 auf, die hinter dem Verstärker 80 und vor dem Pulskompressor 110 angeordnet ist.

Mithilfe zumindest einer der Pulsauswahleinrichtungen 60, 90 können in der Niederfrequenz-Funktionsstellung insbesondere Niederfrequenz-Pulspakete mit mindestens zwei Einzelpulsen und einer Einzelpuls-Repetitionsrate der Einzelpulse (Mikropulse) innerhalb eines solchen Niederfrequenz-Pulspakets (Mikropulsrepetitionsrate) von weniger als 0,5 GHz, vorzugsweise von mindestens 0,01 MHz bis höchstens 100 MHz, vorzugsweise von mindestens 1 MHz bis höchstens 90 MHz, vorzugsweise von mindestens 5 MHz bis höchstens 15 MHz, vorzugsweise höchstens 10 MH, erzeugt werden. Die Niederfrequenz-Pulspakete folgen bevorzugt zeitlich aufeinander mit einer Niederfrequenz-Pulspaket-Repetitionsrate (Makropulsrepetitionsrate) von einigen 100 kHz, einigen 10 kHz oder einigen kHz.

Mithilfe zumindest einer der Pulsauswahleinrichtungen 60, 90 können auch die GHz-Laserpulszüge als GHz-Pulspakete geschnitten werden, die eine Einzelpuls-Repetitionsrate von mindestens 0,5 GHz, vorzugsweise von mehr als 0,5 GHz, vorzugsweise von mindestens 1 GHz bis höchstens 100 GHz, vorzugsweise von mindestens 2 GHz bis höchstens 20 GHz, vorzugsweise bis höchstens 10 GHz, vorzugsweise 1 GHz, 3,5 GHz, oder 5 GHz, aufweisen. Die GHz-Pulspakete folgen bevorzugt mit einer GHz-Pulspaket-Repetitionsrate (Makropulsrepetitionsrate) aufeinander, die bevorzugt mehr als 1 kHz beträgt oder im MHz-Bereich liegt, wobei die GHz-Pulspaket-Repetitionsrate auch weniger als 1 kHz betragen kann.

Es ist aber auch möglich, die Laserpulszüge, seien es GHz- oder Niederfrequenz-Laserpulszüge, als Einzelpulszüge ohne definierte Pulspaket-Repetitionsrate zu erzeugen.

In bevorzugter Ausgestaltung ist es möglich, dass hinter dem Pulskompressor 110 eine oder mehrere nicht-lineare optische Komponenten 120 angeordnet sind, die eingerichtet ist/sind zur Frequenzumwandlung des Laserlichts des Anregungslasers 10, insbesondere zur Frequenzvervielfachung, beispielsweise Frequenzverdopplung oder Frequenzverdreifachung, beispielsweise zur Erzeugung einer zweiten Harmonischen der Anregungswellenlänge.

Außerdem weist das Lasersystem 100 vorzugsweise eine Steuereinrichtung 130 auf, die eingerichtet ist zur Ansteuerung der Strahlumschalteinrichtung 31, 33, um von der Hochfrequenz-Funktionsstellung in die Niederfrequenz-Funktionsstellung - oder umgekehrt - umzuschalten.

Der Anregungslaser 10 ist bevorzugt als Faseroszillator ausgebildet.

Bei dem hier dargestellten, ersten Ausführungsbeispiel ist die Modus-Änderungseinrichtung 30 vor der Pulsauswahleinrichtung 60 sowie vor dem ersten Vorverstärker 50 und vor dem zweiten Vorverstärker 70 angeordnet. Insbesondere ist die Modus-Änderungseinrichtung 30 unmittelbar hinter dem Pulsstrecker 20 und vor dem ersten Vorverstärker 50 angeordnet.

**Fig. 2** zeigt ein Ausführungsbeispiel der Modus-Änderungseinrichtung 30. Diese weist hier die Strahlumschalteinrichtung 31, 33 auf, die ihrerseits einen hier als Strahlumschalter ausgebildeten Strahlwähler 33 sowie einen Strahlverteiler 31 aufweist. Der Strahlverteiler 31 ist dabei eingerichtet, um einen Laserstrahl oder Laserpuls aufzuteilen auf zwei Strahlstrecken, hier insbesondere auf die Hochfrequenz-Laserpulsquelle 40 einerseits und eine Einzelpulsstrecke 32 andererseits. Der Strahlwähler 33 ist eingerichtet, um Laserlicht oder Laserpulse aus den beiden Strahlstrecken auf einen gemeinsamen Pfad zu leiten, insbesondere zu einer gemeinsamen Zielposition.

Die Hochfrequenz-Laserpulsquelle 40 ist hier als Repetitionsratenvervielfacher 47 ausgebildet, wobei dem Repetitionsratenvervielfacher 47 Laserpulse aus dem Anregungslaser 10 zuleitbar sind. Der Repetitionsratenvervielfacher 47 ist eingerichtet, um eine Einzelpuls-Repetitionsrate der Einzelpulse des Anregungslasers 10 zu vervielfachen.

Die Modus-Änderungseinrichtung 30 weist insbesondere den Strahlverteiler 31, den Repetitionsratenvervielfacher 47, die Einzelpulsstrecke 32 und den Strahlwähler 33 auf.

Der Strahlverteiler 31 ist hier eingerichtet, um Laserlicht des Anregungslasers 10 zeitlich und/oder räumlich auf den Repetitionsratenvervielfacher 47 einerseits und die Einzelpulsstrecke 32 andererseits aufzuteilen. Der Strahlwähler 33 ist eingerichtet, um dem Verstärker 80 in der Hochfrequenz-Funktionsstellung wenigstens einen GHz-Laserpulszug aus dem Repetitionsratenvervielfacher 47, und in der Niederfrequenz-Funktionsstellung Laserpulse aus der Einzelpulsstrecke 32 zuzuleiten.

Insbesondere ist der Strahlverteiler 31 bevorzugt als passiver Strahlteiler, vorzugsweise mit konstantem Aufteilungsverhältnis, ausgebildet. Alternativ kann der Strahlverteiler 31 auch als aktive Strahlschalteinrichtung, insbesondere als akustooptischer Modulator, als elektrooptischer Modulator, oder als mikro-elektro-mechanisches System, ausgebildet sein.

Schließlich ist es auch möglich, dass der Strahlverteiler 31 als Kombination aus einem passiven Strahlteiler und einer aktiven Strahlschalteinrichtung ausgebildet ist.

Der Strahlwähler 33 ist bevorzugt als aktive Strahlschalteinrichtung, insbesondere als akustooptischer Modulator, als elektrooptischer Modulator, oder als mikro-elektro-mechanisches System ausgebildet. Alternativ ist es auch möglich, dass der Strahlwähler 33 als Kombination aus einem passiven Strahlkombinierer mit wenigstens einer aktiven Strahlbeeinflussungseinrichtung, bevorzugt mit jeweils einer aktiven Strahlbeeinflussungseinrichtung jeder Strahlstrecke, hier also in der Einzelpulsstrecke 32 einerseits und dem Repetitionsratenvervielfacher 47 andererseits, ausgebildet.

Ist der Strahlwähler 33 nicht als aktiver Strahlumschalter ausgebildet, so kann er alternativ auch als passiver Strahlkombinierer ausgebildet sein. Dies ist insbesondere dann möglich, wenn der Strahlverteiler 31 als aktive Strahlschalteinrichtung oder als Kombination aus einem passiven Strahlteiler und einer aktiven Strahlschalteinrichtung ausgebildet ist.

Sowohl die Einzelpulsstrecke 32 als auch der Repetitionsratenvervielfacher 47 sind bevorzugt als faseroptische Komponenten ausgebildet oder weisen faseroptische Komponenten auf. Die Einzelpulsstrecke 32 weist bevorzugt eine Einzelpuls-Verzögerungsstrecke 34 zum Ausgleich von Dispersion auf.

Der Repetitionsratenvervielfacher 47 weist eingangsseitig einen Vervielfacher-Strahlteiler 41 auf, der die ankommenden Laserpulse aufteilt auf eine Verzögerungsstrecke 42 einerseits und eine Durchgangsstrecke 43 andererseits. Die Verzögerungsstecke 42 weist dabei einen längeren Lichtweg auf als die Durchgangsstrecke 43, sodass der die Verzögerungsstrecke 42 durchlaufende Laserpuls relativ zu dem die Durchgangsstrecke 43 durchlaufenden Laserpuls verzögert wird.

Der Repetitionsratenvervielfacher 47 weist außerdem eine Mehrzahl von Kombinationselementen 44, die jeweils einen Strahlkombinierer und einen Strahlteiler miteinander kombinieren, auf, wobei hier jeweils die Laserstrahlung aus der Durchgangsstrecke 43 einerseits und der Verzögerungsstrecke 42 andererseits zunächst miteinander kombiniert und dann wieder aufgeteilt wird auf eine nachfolgende Verzögerungsstrecke 42 und eine nachfolgende Durchgangsstrecke 43. Dies kann grundsätzlich beliebig oft wiederholt werden, wobei bevorzugt aufeinanderfolgende Verzögerungsstrecken 42 jeweils eine sich je nach Ausgestaltung des Repetitionsratenvervielfachers 47 verdoppelnde oder - wie bei dem hier dargestellten Ausführungsbeispiel - halbierende Länge aufweisen, sodass im Ergebnis entweder den Repetitionsratenvervielfacher durchlaufende Laserpulszüge vervielfacht, oder - wie bei dem hier dargestellten Ausführungsbeispiel - die Einzelpuls-Repetitionsrate vervielfacht wird, nämlich pro durchlaufener Verzögerungsstrecke um einen Faktor 2. Ausgangsseitig weist der Repetitionsratenvervielfacher 47 einen Vervielfacher-Strahlkombinierer 45 auf, der die Laserstrahlung aus einer letzten Durchgangsstrecke 43 mit der Laserstrahlung aus einer letzten Verzögerungsstrecke 42 kombiniert und als GHz-Laserpulszug an den Strahlwähler 33 weiterleitet.

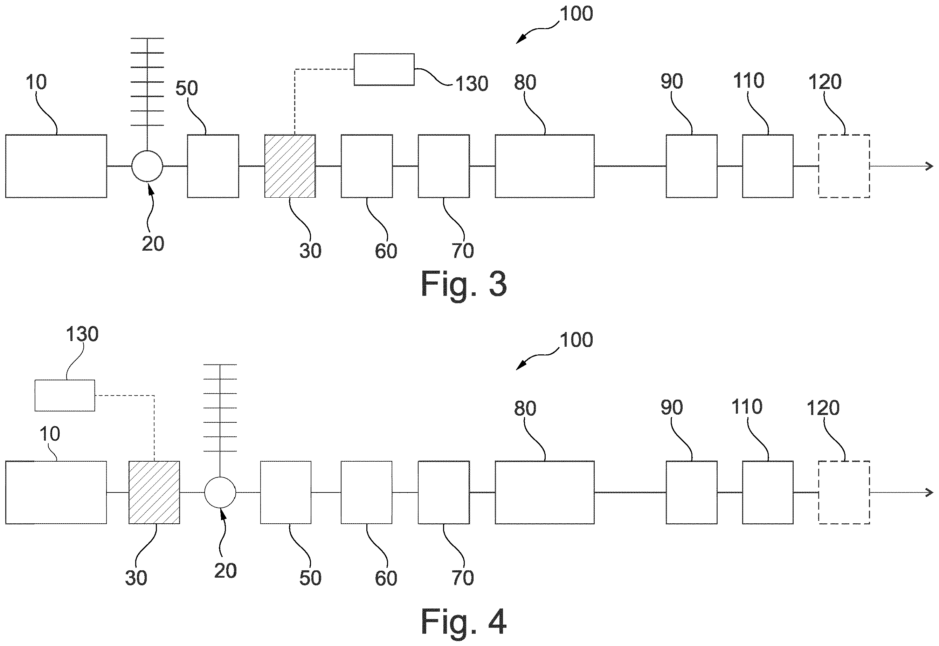

**Fig. 3** zeigt eine schematische Darstellung eines zweiten Ausführungsbeispiels des Lasersystems 100.

Gleiche und funktionsgleiche Elemente sind in allen Figuren stets mit gleichen Bezugszeichen versehen, sodass insoweit jeweils auf die vorangegangene Beschreibung verwiesen wird.

Das zweite Ausführungsbeispiel gemäß Figur 3 unterscheidet sich von dem ersten Ausführungsbeispiel gemäß Figur 1 insoweit, als hier die Modus-Änderungseinrichtung 30 hinter dem ersten Vorverstärker 50, hier insbesondere unmittelbar hinter dem ersten Vorverstärker 50 und unmittelbar vor der Pulsauswahleinrichtung 60 angeordnet ist. Außerdem ist sie vor dem zweiten Vorverstärker 70 angeordnet.

In den Ausführungsbeispielen gemäß den Figuren 1 und 3 ist die Modus-Änderungseinrichtung 30 jeweils hinter dem Pulsstrecker 20 und vor der Pulsauswahleinrichtung 60 angeordnet. In diesem Fall sieht sie relativ viel Signal, es ergibt sich jedoch bei Verwendung einer langsamen Pulsauswahleinrichtung 60 wie beispielsweise eines akustooptischen Modulators das Problem, dass die durch die Hochfrequenz-Laserpulsquelle 40 erzeugten GHz-Laserpulszüge durch die Pulsauswahleinrichtung 60 zeitlich geformt werden können, wobei flache Flanken entstehen. Dies ist unkritisch bei zeitlich ausreichend langen GHz-Laserpulszügen. Weiterhin ist es unkritisch wenn als Pulsauswahleinrichtung 60 ein schneller Modulator wie beispielsweise ein elektrooptischer Modulator verwendet wird.

**Fig. 4** zeigt eine schematische Darstellung eines dritten Ausführungsbeispiels des Lasersystems 100. Hierbei ist die Modus-Änderungseinrichtung 30 vor dem Pulsstrecker 20, insbesondere unmittelbar vor dem Pulsstrecker 20 angeordnet. In diesem Fall sieht die Hochfrequenz-Laserpulsquelle 40, insbesondere der Repetitionsratenvervielfacher 47, kurze Pulse, die möglicherweise eine zu hohe Pulsspitzenleistung aufweisen können, sodass vorteilhaft mit einem kleinen Signal des Anregungslasers 10 gearbeitet wird.

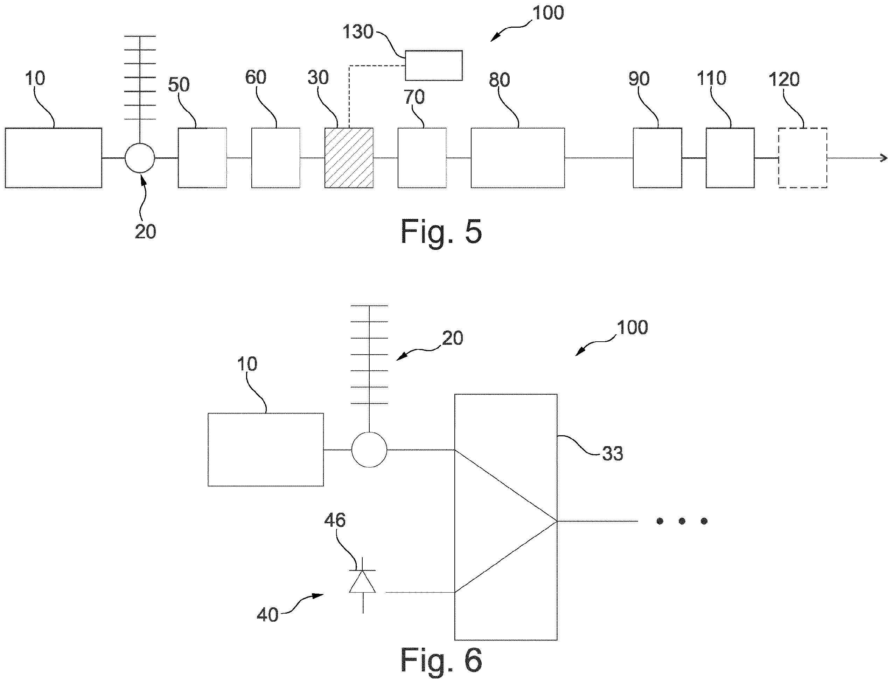

**Fig. 5** zeigt eine schematische Darstellung eines vierten Ausführungsbeispiels des Lasersystems 100. Hierbei ist die Modus-Änderungseinrichtung 30 in Lichtausbreitungsrichtung hinter der Pulsauswahleinrichtung 60, insbesondere unmittelbar hinter der Pulsauswahleinrichtung 60, sowie vorzugsweise unmittelbar vor dem zweiten Vorverstärker 70 angeordnet. Die Anordnung hinter der Pulsauswahleinrichtung 60 hat den Vorteil, dass aus einem einzigen Laserpuls ein GHz-Laserpulszug erzeugt werden kann, der sehr steile Flanken, dafür allerdings weniger Signal aufweist.

Alternativ ist es in hier nicht dargestellter Weise auch möglich, dass die Modus-Änderungseinrichtung 30 hinter dem zweiten Vorverstärker 70, bevorzugt unmittelbar hinter dem zweiten Vorverstärker 70, besonders bevorzugt vor dem Verstärker 80, besonders bevorzugt unmittelbar vor dem Verstärker 80, angeordnet ist.

**Fig. 6** zeigt eine schematische Darstellung eines fünften Ausführungsbeispiels des Lasersystems 100. Hierbei ist die Hochfrequenz-Laserpulsquelle 40 als Laserdiode 46, insbesondere eingerichtet zur Erzeugung von Pikosekunden-Pulsen, eingerichtet. Bevorzugt ist die Laserdiode 46 eingerichtet, um Laserpulse mit einer Einzelpuls-Repetitionsrate im GHz-Bereich zu erzeugen. Es ist aber auch möglich, die Laserdiode 46 mit einem ihr zugeordneten Dioden-Repetitionsratenvervielfacher zu kombinieren.

Die Strahlumschalteinrichtung 31, 33 weist bei diesem Ausführungsbeispiel lediglich den als Strahlumschalter ausgebildeten Strahlwähler 33 auf, der hier vorzugsweise einerseits Licht aus dem Anregungslaser 10 sowie dem Pulsstrecker 20 und andererseits aus der Laserdiode 46 - gegebenenfalls kombiniert mit einem Dioden-Repetitionsratenvervielfacher - empfängt. Dieses Licht wird einem gemeinsamen weiteren Lichtpfad zugeführt. In diesem folgen dann in bevorzugter Ausgestaltung der erste Vorverstärker 50, die Pulsauswahleinrichtung 60, der zweite Vorverstärker 70, der Verstärker 80, bevorzugt die zweite Pulsauswahleinrichtung 90, der Pulskompressor 110, und gegebenenfalls - optional - die wenigstens eine nicht-lineare optische Komponente 120, gegebenenfalls in dieser oder einer anderen geeigneten Reihenfolge.

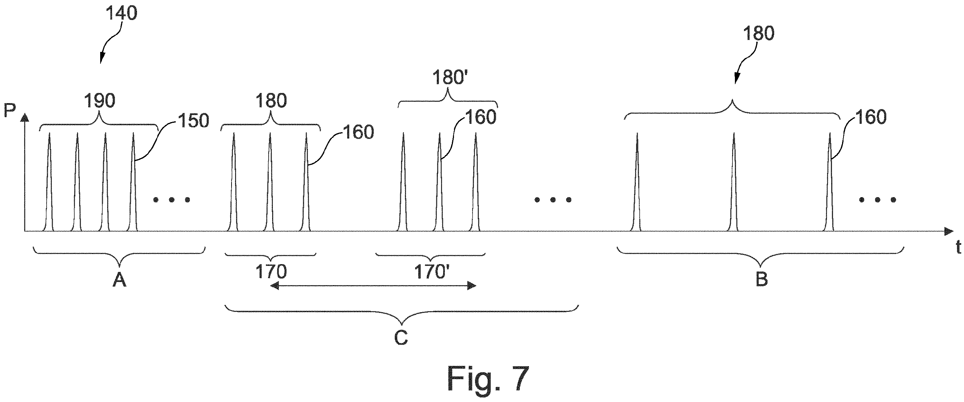

**Fig. 7** zeigt eine schematische Darstellung einer Funktionsweise des Lasersystems 100.

Dabei ist in einem Diagramm hier eine momentane Laserleistung P insbesondere ausgangseitig des Lasersystems 100 gegen die Zeit t aufgetragen. Dabei ist bei A eine Betriebsweise des Lasersystems 100 in der Hochfrequenz-Funktionsstellung der Strahlumschalteinrichtung 31, 33 dargestellt. Hierbei werden GHz-Laserpulszüge 140 erzeugt, wobei hier ein GHz-Einzelpulszug 190 hier beispielhaft dargestellt ist. Dieser weist Einzelpulse 150 auf, die mit einer Einzelpuls-Repetitionsrate von mindestens 0,5 GHz innerhalb des GHz-Laserpulszugs 140 aufeinanderfolgen. Bevorzugt kann eine Mehrzahl solcher GHz-Laserpulszüge 140 als GHz-Pulspakete erzeugt werden, die ihrerseits mit einer GHz-Pulspaket-Repetitionsrate von mehr als einem kHz, oder auch im MHz Bereich, aufeinanderfolgen.

Bei B ist eine erste Ausgestaltung einer Betriebsweise des Lasersystems 100 in der Niederfrequenz-Funktionsstellung der Strahlumschalteinrichtung 31, 33 dargestellt, wobei hier wenigstens ein Niederfrequenz-Laserpulszug 180 mit einzelnen Laserpulse 160 mit einer Einzelpuls-Repetitionsrate von weniger als 0,5 GHz, insbesondere mit einer Einzelpuls-Repetitionsrate von einigen kHz, oder auch im MHz-Bereich als Niederfrequenz-Einzelpulszug erzeugt wird.

Bei C ist eine zweite Ausgestaltung der Betriebsweise des Lasersystems 100 in der Niederfrequenz-Funktionsstellung dargestellt, wobei zwei Niederfrequenz-Laserpulszüge 180, 180` dargestellt sind, und wobei hier die Laserpulse 160 zu Niederfrequenz-Pulspakten 170, 170` kombiniert sind, von denen hier ein erstes Niederfrequenz-Pulspaket 170 und ein zweites Niederfrequenz-Pulspaket 170` dargestellt sind. Eine Einzelpuls-Repetitionsrate der einzelnen Laserpulse innerhalb der Niederfrequenz-Pulspakete 170, 170` beträgt bevorzugt von mindestens 0,01 MHz bis höchstens 100 MHz, vorzugsweise von mindestens 1 MHz bis höchstens 90 MHz, vorzugsweise von mindestens 5 MHz bis höchstens 15 MHz, vorzugsweise höchstens 10 MH. Die Niederfrequenz-Pulspakete 170, 170` folgen bevorzugt zeitlich aufeinander mit einer Niederfrequenz-Pulspaket-Repetitionsrate von einigen kHz, einigen 10 kHz oder einigen 100 kHz.

Es wird ein Verfahren zum Betreiben des Lasersystems 100 bevorzugt, wobei die Strahlumschalteinrichtung 31, 33 des Lasersystems 100 wahlweise in die Hochfrequenz-Funktionsstellung oder in die Niederfrequenz-Funktionsstellung geschaltet wird, um in der Hochfrequenz-Funktionsstellung wenigstens einen GHz-Laserpulszug 140 mit einer Einzelpuls-Repetitionsrate von Einzelpulsen 150 in dem GHz-Laserpulszug 140 von mindestens 0,5 GHz von der Hochfrequenz-Laserpulsquelle 40 zu einer Zielposition zu leiten, und um in der Niederfrequenz-Funktionsstellung wenigstens einen Niederfrequenz-Laserpulszug 180, 180` mit einer Einzelpuls-Repetitionsrate von weniger als 0,5 GHz von dem Anregungslaser 10 zu der Zielposition zu leiten.

Insofern wird auch ein Lasersystem 100 bevorzugt, welches die Hochfrequenz-Laserpulsquelle 40, den Anregungslaser 10 und die Strahlumschalteinrichtung 31, 33 aufweist, welches eingerichtet ist zur Durchführung eines solchen Verfahrens.

## Patentansprüche

1. Lasersystem (100), mit
- wenigstens einem Anregungslaser (10), eingerichtet zur Erzeugung von Laserpulsen (160),
- einem Verstärker (80), eingerichtet zur Verstärkung von Laserlicht, und mit
- einer Hochfrequenz-Laserpulsquelle (40), eingerichtet zur Erzeugung eines GHz-Laserpulszugs (140) mit einer Einzelpuls-Repetitionsrate von Einzelpulsen (150) in dem GHz-Laserpulszug (140) von mindestens 0,5 GHz,
**dadurch gekennzeichnet, dass**
- in Lichtausbreitungsrichtung vor dem Verstärker (80) eine Strahlumschalteinrichtung (31,33) angeordnet ist, die zwischen einer Hochfrequenz-Funktionsstellung und einer Niederfrequenz-Funktionsstellung schaltbar und eingerichtet ist, um
a) in der Hochfrequenz-Funktionsstellung dem Verstärker (80) wenigstens einen GHz-Laserpulszug (140) der Hochfrequenz-Laserpulsquelle (40) zur Verstärkung zuzuleiten, und
b) in der Niederfrequenz-Funktionsstellung dem Verstärker (80) wenigstens einen Niederfrequenz-Laserpulszug (180) mit einer Einzelpuls-Repetitionsrate von einzelnen Laserpulsen (160) in dem Niederfrequenz-Laserpulszug (180) von weniger als 0,5 GHz des wenigstens einen Anregungslasers (10) zur Verstärkung zuzuleiten,
- die Strahlumschalteinrichtung (31,33) wenigstens einen Strahlwähler (33) und wenigstens einen Strahlverteiler (31) aufweist, wobei aus dem Anregungslaser (10) stammende Laserpulse zunächst durch den Strahlverteiler (31) auf verschiedene Strahlstrecken aufgeteilt werden und anschließend aus den verschiedenen, als verschiedene Quellen wirkenden Strahlstrecken stammende Laserpulse durch den Strahlwähler (33) je nach Funktionsstellung des Strahlverteilers (31) und des Strahlwählers (33) ausgewählt und zu dem Verstärker (80) geleitet werden.

2. Lasersystem (100) nach Anspruch 1, **dadurch gekennzeichnet, dass** die Hochfrequenz-Laserpulsquelle (40) als Laserdiode (46) ausgebildet ist.

3. Lasersystem (100) nach einem der vorhergehenden Ansprüche, **dadurch gekennzeichnet, dass** die Hochfrequenz-Laserpulsquelle (40) als Repetitionsratenvervielfacher (47) ausgebildet ist, wobei dem Repetitionsratenvervielfacher (47) vorzugsweise Laserpulse (160) aus dem Anregungslaser (10) zuleitbar sind, wobei der Repetitionsratenvervielfacher (47) eingerichtet ist, um eine Einzelpuls-Repetitionsrate der Einzelpulse (160) des Anregungslasers (10) zu vervielfachen.

4. Lasersystem (100) nach einem der vorhergehenden Ansprüche, **dadurch gekennzeichnet, dass** die Strahlumschalteinrichtung (31,33) einen Strahlverteiler (31) aufweist, der eingerichtet ist, um Laserlicht des Anregungslasers (10) zeitlich und/oder räumlich auf den Repetitionsratenvervielfacher (47) einerseits und eine Einzelpulsstrecke (32) andererseits aufzuteilen, wobei die Strahlumschalteinrichtung (31,33) außerdem einen Strahlwähler (33) aufweist, der eingerichtet ist, um dem Verstärker (80) in der Hochfrequenz-Funktionsstellung wenigstens einen GHz-Laserpulszug (140) aus dem Repetitionsratenvervielfacher (47) und in der Niederfrequenz-Funktionsstellung Laserpulse (160) aus der Einzelpulsstrecke (32) zuzuleiten.

5. Lasersystem (100) nach einem der vorhergehenden Ansprüche, **dadurch gekennzeichnet, dass** der Strahlverteiler (31) als
a) passiver Strahlteiler, oder
b) aktive Strahlschalteinrichtung, oder
c) Kombination aus einem passiven Strahlteiler und einer aktiven Strahlschalteinrichtung ausgebildet ist.

6. Lasersystem (100) nach einem der vorhergehenden Ansprüche, **dadurch gekennzeichnet, dass** der Strahlwähler (33) als
a) aktive Strahlschalteinrichtung, oder
b) Kombination aus einem passiven Strahlkombinierer mit wenigstens einer aktiven Strahlbeeinflussungseinrichtung, oder
c) passiver Strahlkombinierer
ausgebildet ist.

7. Lasersystem (100) nach einem der vorhergehenden Ansprüche, **dadurch gekennzeichnet, dass** die Strahlumschalteinrichtung (31,33) zumindest eine aktive Strahlschalteinrichtung aufweist, die ausgebildet ist als
a) akustooptischer Modulator,
b) elektrooptischer Modulator, oder
c) mikro-elektro-mechanisches System.

8. Lasersystem (100) nach einem der vorhergehenden Ansprüche, **gekennzeichnet durch** eine Modus-Änderungseinrichtung (30), die den Strahlverteiler (31), den Repetitionsratenvervielfacher (47), die Einzelpulsstrecke (32) und den Strahlwähler (33) aufweist, wobei die Modus-Änderungseinrichtung (30) in Lichtausbreitungsrichtung
a) vor einer Pulsauswahleinrichtung (60) zur Auswahl von Einzelpulsen oder einzelnen Laserpulszügen,
b) vor einem ersten Vorverstärker (50) des Lasersystems (100),
c) vor einem Pulsstrecker (20),
d) hinter dem ersten Vorverstärker (50), und/oder
e) hinter der Pulsauswahleinrichtung (60)
angeordnet ist.

9. Lasersystem (100) nach einem der vorhergehenden Ansprüche, **dadurch gekennzeichnet, dass** das Lasersystem (100) in Lichtausbreitungsrichtung hinter dem Anregungslaser (10) einen Pulsstrecker (20), einen ersten Vorverstärker (50), vorzugsweise einen zweiten Vorverstärker (70), den Verstärker (80), und einen Pulskompressor (110) aufweist.

10. Lasersystem (100) nach einem der vorhergehenden Ansprüche, **dadurch gekennzeichnet, dass** der Anregungslaser (10) als Faseroszillator ausgebildet ist.

11. Lasersystem (100) nach einem der vorhergehenden Ansprüche, **gekennzeichnet durch** eine Steuereinrichtung (130), die eingerichtet ist zur Ansteuerung der Strahlumschalteinrichtung (31,33).

12. Verfahren zum Betreiben eines Lasersystems (100) nach einem der Ansprüche 1 bis 11, wobei eine Strahlumschalteinrichtung (31,33) des Lasersystems (100) wahlweise in eine Hochfrequenz-Funktionsstellung und eine Niederfrequenz-Funktionsstellung geschaltet wird, um
a) in der Hochfrequenz-Funktionsstellung wenigstens einen GHz-Laserpulszug (140) mit einer Einzelpuls-Repetitionsrate von Einzelpulsen (150) in dem GHz-Laserpulszug (140) von mindestens 0,5 GHz von einer Hochfrequenz-Laserpulsquelle (40) zu einer Zielposition zu leiten, und
b) in der Niederfrequenz-Funktionsstellung wenigstens einen Niederfrequenz-Laserpulszug (180) mit einer Einzelpuls-Repetitionsrate von einzelnen Laserpulsen (160) in dem Niederfrequenz-Laserpulszug (180) von weniger als 0,5 GHz von wenigstens einem Anregungslaser (10) zu der Zielposition zu leiten.

## Claims

1. A laser system (100) having
- at least one excitation laser (10) designed to generate laser pulses (160),
- an amplifier (80) designed to amplify laser light, and having
- a high-frequency laser pulse source (40) designed to generate a GHz laser pulse train (140) with a single pulse repetition rate of single pulses (150) in the GHz laser pulse train (140) of at least 0.5 GHz,
**characterized in that**
- a beam switchover device (31,33) is arranged in front of the amplifier (80) in the direction of light propagation, which device can be switched between a high-frequency functional position and a low-frequency functional position and is designed
a) to supply at least one GHz laser pulse train (140) of the high-frequency laser pulse source (40) to the amplifier (80) for amplification in the high-frequency functional position, and
b) to supply at least one low-frequency laser pulse train (180) with a single pulse repetition rate of individual laser pulses (160) in the low-frequency laser pulse train (180) of less than 0.5 GHz of the at least one excitation laser (10) to the amplifier (80) for amplification in the low-frequency functional position,
- the beam switchover device (31,33) has at least one beam selector (33) and at least one beam distributor (31), wherein laser pulses originating from the excitation laser (10) are first split into different beam paths by the beam distributor (31) and subsequently laser pulses originating from the different beam paths acting as different sources are selected by the beam selector (33) depending on the functional position of the beam distributor (31) and the beam selector (33) and are guided to the amplifier (80).

2. The laser system (100) according to claim 1, **characterized in that** the high-frequency laser pulse source (40) is designed as a laser diode (46).

3. The laser system (100) according to any one of the preceding claims, **characterized in that** the high-frequency laser pulse source (40) is configured as a repetition rate multiplier (47), wherein laser pulses (160) from the excitation laser (10) can preferably be supplied to the repetition rate multiplier (47), wherein the repetition rate multiplier (47) is designed to multiply a single pulse repetition rate of the single pulses (160) of the excitation laser (10).

4. The laser system (100) according to any one of the preceding claims, **characterized in that** the beam switchover device (31,33) has a beam distributor (31) which is designed to split laser light of the excitation laser (10) temporally and/or spatially between the repetition rate multiplier (47) on the one hand and a single pulse path (32) on the other hand, wherein the beam switchover device (31,33) further has a beam selector (33) which is designed to supply to the amplifier (80) at least one GHz laser pulse train (140) from the repetition rate multiplier (47) in the high-frequency functional position and laser pulses (160) from the single pulse path (32) in the low-frequency functional position.

5. The laser system (100) according to any one of the preceding claims, **characterized in that** the beam distributor (31) is designed as
a) a passive beam splitter, or
b) an active beam switching device, or
c) a combination of a passive beam splitter and an active beam switching device.

6. The laser system (100) according to any one of the preceding claims, **characterized in that** the beam selector (33) is designed as
a) an active beam switching device, or
b) a combination of a passive beam combiner with at least one active beam influencing device, or
c) a passive beam combiner.

7. The laser system (100) according to any one of the preceding claims, **characterized in that** the beam switchover device (31,33) has at least one active beam switching device which is designed as
a) an acousto-optical modulator,
b) an electro-optical modulator, or
c) a micro-electromechanical system.

8. The laser system (100) according to any one of the preceding claims, **characterized by** a mode changing device (30) having the beam distributor (31), the repetition rate multiplier (47), the single pulse path (32) and the beam selector (33), wherein the mode changing device (30) is arranged in the direction of light propagation
a) upstream of a pulse selection device (60) for selecting individual pulses or individual laser pulse trains,
b) upstream of a first preamplifier (50) of the laser system (100),
c) upstream of a pulse stretcher (20),
d) downstream of the first preamplifier (50), and/or
e) downstream of the pulse selection device (60).

9. The laser system (100) according to any one of the preceding claims, **characterized in that** the laser system (100) has a pulse stretcher (20), a first preamplifier (50), preferably a second preamplifier (70), the amplifier (80), and a pulse compressor (110) downstream of the excitation laser (10) in the direction of light propagation.

10. The laser system (100) according to any one of the preceding claims, **characterized in that** the excitation laser (10) is designed as a fibre oscillator.

11. The laser system (100) according to any one of the preceding claims, **characterized by** a control device (130) which is designed to drive the beam switchover device (31,33).

12. A method for operating a laser system (100) according to any one of claims 1 to 11, wherein a beam switchover device (31,33) of the laser system (100) is selectively switched to a high-frequency functional position and a low-frequency functional position in order,
a) in the high-frequency functional position, to guide at least one GHz laser pulse train (140) with a single pulse repetition rate of single pulses (150) in the GHz laser pulse train (140) of at least 0.5 GHz from a high-frequency laser pulse source (40) to a target position, and,
b) in the low-frequency functional position, to guide at least one low-frequency laser pulse train (180) with a single pulse repetition rate of individual laser pulses (160) in the low-frequency laser pulse train (180) of less than 0.5 GHz from at least one excitation laser (10) to the target position.

## Revendications

1. Système laser (100), comportant
- au moins un laser (10) d'excitation, conçu pour générer des impulsions laser (160),
- un amplificateur (80), conçu pour amplifier la lumière laser, et comportant
- une source (40) d'impulsions laser haute fréquence, conçue pour générer un train (140) d'impulsions laser GHz présentant un taux de répétition d'impulsion individuelle des impulsions (150) individuelles dans le train (140) d'impulsions laser GHz d'au moins 0,5 GHz,
**caractérisé en ce que**
- dans la direction de propagation de la lumière en amont de l'amplificateur (80) est disposé un dispositif de commutation (31, 33) de faisceau qui peut être commuté entre une position fonctionnelle haute fréquence et une position fonctionnelle basse fréquence et est conçu
a) pour transmettre, dans la position fonctionnelle haute fréquence à l'amplificateur (80), au moins un train (140) d'impulsions laser GHz de la source (40) d'impulsions laser haute fréquence pour qu'il soit amplifié, et
b) pour transmettre, dans la position fonctionnelle basse fréquence à l'amplificateur (80), au moins un train (180) d'impulsions laser basse fréquence présentant un taux de répétition d'impulsion individuelle des impulsions laser (160) individuelles dans le train (180) d'impulsions laser basse fréquence inférieur à 0,5 GHz de l'au moins un laser (10) d'excitation pour qu'il soit amplifié,
- le dispositif de commutation (31, 33) de faisceau comprend au moins un sélecteur (33) de faisceau et au moins un répartiteur (31) de faisceau, dans lequel les impulsions laser provenant du laser (10) d'excitation sont d'abord divisées, par le répartiteur (31) de faisceau, dans différentes trajectoires de faisceau et ensuite les impulsions laser provenant des différents trajectoires de faisceau agissant comme différentes sources sont sélectionnées par le sélecteur (33) de faisceau en fonction de la position fonctionnelle du répartiteur (31) de faisceau et du sélecteur (33) de faisceau et dirigées vers l'amplificateur (80).

2. Système laser (100) selon la revendication 1, **caractérisé en ce que** la source (40) d'impulsions laser haute fréquence est conçue sous la forme de diode (46) laser.

3. Système laser (100) selon l'une quelconque des revendications précédentes, **caractérisé en ce que**, la source (40) d'impulsions laser haute fréquence est conçue sous la forme de multiplicateur (47) de taux de répétition, dans lequel, de préférence les impulsions laser (160) provenant du laser (10) d'excitation peuvent être transmises au multiplicateur (47) de taux de répétition, dans lequel le multiplicateur (47) de taux de répétition est conçu pour multiplier un taux de répétition d'impulsion individuelle des impulsions (160) individuelles du laser (10) d'excitation.

4. Système laser (100) selon l'une quelconque des revendications précédentes, **caractérisé en ce que** le dispositif de commutation (31, 33) de faisceau comprend un répartiteur (31) de faisceau, qui est conçu pour diviser la lumière laser du laser (10) d'excitation dans le temps et/ou dans l'espace entre le multiplicateur (47) de taux de répétition, d'une part, et une trajectoire (32) d'impulsion individuelle, d'autre part, dans lequel le dispositif de commutation (31, 33) de faisceau comprend en outre un sélecteur (33) de faisceau, qui est conçu pour transmettre à l'amplificateur (80) dans la position fonctionnelle haute fréquence l'au moins un train (140) d'impulsions laser GHz provenant du multiplicateur (47) de taux de répétition et les impulsions laser (160) dans la position fonctionnelle basse fréquence provenant de la trajectoire (32) d'impulsion individuelle.

5. Système laser (100) selon l'une quelconque des revendications précédentes, **caractérisé en ce que** le répartiteur (31) de faisceau est conçu sous la forme
a) de séparateur de faisceau passif, ou
b) de dispositif de commutation de faisceau actif, ou
c) d'un séparateur de faisceau passif et d'un dispositif de commutation de faisceau actif combinés.

6. Système laser (100) selon l'une quelconque des revendications précédentes, **caractérisé en ce que** le sélecteur (33) de faisceau est conçu sous la forme
a) de dispositif de commutation de faisceau actif, ou
b) d'un combineur de faisceaux passif et d'au moins un dispositif d'influence de faisceau actif combinés, ou
c) de combinateur de faisceaux passif.

7. Système laser (100) selon l'une quelconque des revendications précédentes, **caractérisé en ce que** le dispositif de commutation (31, 33) de faisceau comprend au moins un dispositif de commutation de faisceau actif, qui est conçu sous la forme
a) de modulateur opto-acoustique,
b) de modulateur opto-électrique, ou
c) de système micro-électro-mécanique.

8. Système laser (100) selon l'une quelconque des revendications précédentes, **caractérisé par** un dispositif de changement de mode (30), qui comprend le répartiteur (31) de faisceau, le multiplicateur (47) de taux de répétition, la trajectoire (32) d'impulsion individuelle et le sélecteur (33) de faisceau, dans lequel le dispositif de changement de mode (30) est disposé, dans la direction de propagation de lumière
a) en amont d'un dispositif de sélection (60) d'impulsions pour sélectionner des impulsions individuelles ou des trains d'impulsions laser individuels,
b) en amont d'un premier préamplificateur (50) du système laser (100),
c) en amont d'un prolongateur (20) d'impulsions,
d) en aval du premier préamplificateur (50), et/ou
e) en aval du dispositif de sélection (60) d'impulsions.

9. Système laser (100) selon l'une quelconque des revendications précédentes, **caractérisé en ce que** le système laser (100) comprend, dans la direction de propagation de la lumière, en aval du laser (10) d'excitation, le prolongateur (20) d'impulsions, un premier préamplificateur (50), de préférence un second préamplificateur (70), l'amplificateur (80) et un compresseur (110) d'impulsions.

10. Système laser (100) selon l'une quelconque des revendications précédentes, **caractérisé en ce que** le laser (10) d'excitation est conçu sous la forme d'oscillateur à fibre.

11. Système laser (100) selon l'une quelconque des revendications précédentes, **caractérisé par** un dispositif de commande (130), qui est conçu pour commander le dispositif de commutation (31, 33) de faisceau.

12. Procédé de fonctionnement d'un système laser (100) selon l'une quelconque des revendications 1 à 11, dans lequel un dispositif de commutation (31, 33) de faisceau du système laser (100) est commuté sélectivement dans une position fonctionnelle haute fréquence et une position fonctionnelle basse fréquence
a) pour diriger, dans la position fonctionnelle haute fréquence, au moins un train (140) d'impulsions laser GHz présentant un taux de répétition des impulsions (150) individuelles dans le train (140) d'impulsions laser GHz d'au moins 0,5 GHz provenant d'une source (40) d'impulsions laser haute fréquence vers une position cible, et
b) pour diriger, dans la position fonctionnelle basse fréquence, au moins un train (180) d'impulsions laser basse fréquence présentant un taux de répétition d'impulsion individuelle des impulsions laser (160) individuelles dans le train (180) d'impulsions laser basse fréquence inférieure à 0,5 GHz provenant d'au moins un laser (10) d'excitation vers la position cible.
